(19) **Europäisches Patentamt European Patent Office Office européen des brevets**

(11) **EP 2 378 295 B1**

(12) **EUROPEAN PATENT SPECIFICATION**

(45) Date of publication and mention
of the grant of the patent:
**11.07.2012 Bulletin 2012/28**

(51) Int Cl.:
***G01R 15/18*** *(2006.01)*

(21) Application number: **10159871.2**

(22) Date of filing: **14.04.2010**

(54) **Method and arrangement for voltage measurement**

Verfahren und Anordnung zur Spannungsmessung

Procédé et agencement pour la mesure de la tension

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(43) Date of publication of application:
**19.10.2011 Bulletin 2011/42**

(73) Proprietor: **ABB Technology AG 8050 Zürich (CH)**

(72) Inventors:
• **Wahlroos, Ari 65350 Vaasa (FI)**

• **Altonen, Janne 37800 Toijala (FI)**
• **Mähönen, Pentti 65320 Vaasa (FI)**

(74) Representative: **Valkeiskangas, Tapio Lassi Paavali Kolster Oy Ab Iso Roobertinkatu 23 P.O. Box 148 00121 Helsinki (FI)**

(56) References cited:
**WO-A1-2009/091803    US-A- 3 916 310
US-A- 4 276 510    US-A1- 2009 219 007**

**Description**

FIELD OF THE INVENTION

The present invention relates to voltage measurement.

BACKGROUND OF THE INVENTION

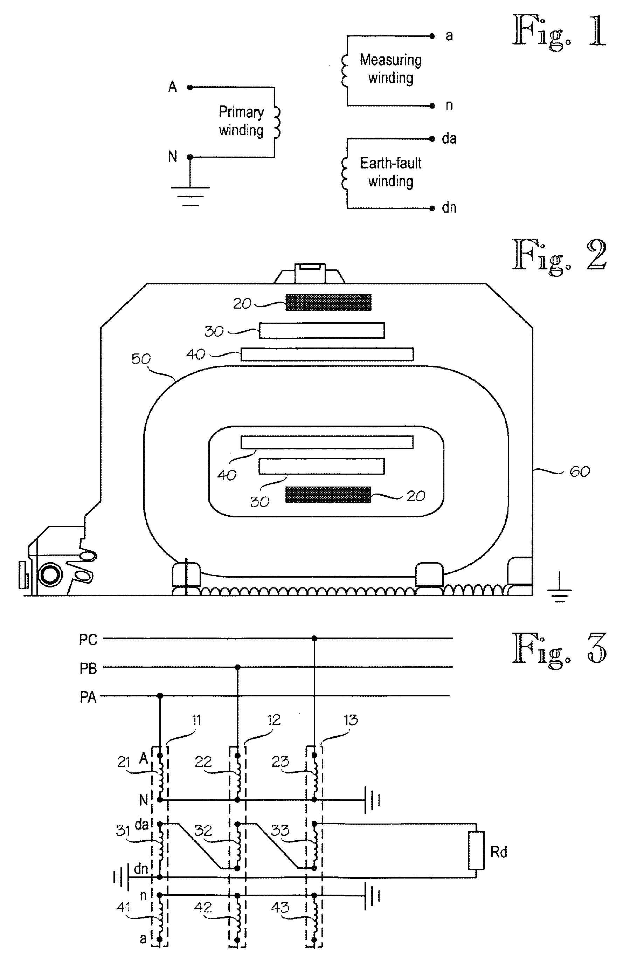

Single pole insulated voltage transformers used in electricity distribution networks are typically equipped with three windings. In addition to a primary winding, transformers have a secondary winding, i.e. a measuring winding, which is used for either measuring or protection purposes, and a tertiary winding, i.e. an earth-fault winding, which is utilized for earth-fault protection purposes. The terminals of the primary, measuring and earth-fault windings are typically denoted as: A-N, a-n and da-dn, respectively. Figure 1 shows a terminal diagram of a single pole insulated voltage transformer with three windings. Typically all three windings are wound around the same magnetic (iron) core. Figure 2 illustrates a principal construction of an exemplary single pole insulated voltage transformer with three windings, i.e. a primary winding 20, an earth-fault winding 30 and a measuring winding 40, wound around a core 50 and enclosed in a housing 60. The fact that all the windings 20, 30, 40 are wound around the same magnetic core 50 makes the windings interlinked through magnetic fluxes. Consequently, when a primary voltage is applied to the primary winding 20, the secondary windings 30, 40 produce secondary voltages that depend on the primary voltage and a turns ratio between the secondary winding in question and the primary winding.

In a three-phase network, the earth-fault windings of three single pole insulated voltage transformers are typically connected in "open-delta" connection. This is due to the fact that during an earth-fault in the primary network, the voltage between the open-delta terminals is related to a residual voltage of the network (voltage between earth and neutral point of the three-phase system). This voltage is utilized in earth-fault protection relays. In addition, typically a resistor is connected between open-delta terminals in order to provide necessary damping power in case of ferro-resonance. Figure 3 shows a typical configuration of three single pole insulated voltage transformers 11, 12, 13 each with primary windings 21, 22, 23, measuring windings 41, 42, 43 and earth-fault windings 31, 32, 33 connected to phases PA, PB, PC of a three-phase network. Earth-fault windings 31, 32, 33 of the three single pole insulated voltage transformers 11, 12, 13 are connected in open-delta connection. A resistor Rd is connected between open-delta terminals in order to provide necessary damping power in case of ferro-resonance. The primary voltages of the three phases PA, PB, PC of the three-phase network may then be obtained on the basis of the secondary voltages measured from the measuring windings 41, 42, 43 and the turns ratio between the primary winding and the measuring winding. However, due to various non-idealities of the transformers, the primary voltages obtained merely on the basis of measured secondary voltages and the turns ratio between the primary winding and the secondary winding may not accurately correspond to true primary voltages.

Document WO 2009/091803 discloses a transformer with two secondary windings. In the disclosed solution the transformer comprises a compensation circuit which comprises a current transformer and an impedance in order to improve an accuracy of a metering voltage by compensating for a voltage drop across primary winding incurred by a load current of a power load connected to a secondary winding. A drawback of the disclosed solution is that it requires an additional current transformer and an impedance to be added to the transformer structure.

BRIEF DESCRIPTION OF THE INVENTION

An object of the present invention is thus to provide a method and an apparatus for implementing the method so as to overcome the above drawback or at least to alleviate it. The objects of the invention are achieved by a method, a computer program product and an arrangement which are characterized by what is stated in the independent claims. The preferred embodiments of the invention are disclosed in the dependent claims.

The invention is based on the idea of applying a correction to the measured secondary voltages on the basis of one or more parameters of the voltage transformers and/or one or more quantities in a known relation to one or more parameters of the voltage transformers, one or more parameters of a circuit connected to the secondary windings and/or one or more quantities in known relation to one or more parameters of the circuit connected to the secondary windings, and one or more parameters of a circuit connected to the tertiary windings and/or one or more quantities in a known relation to one or more parameters of the circuit connected to the tertiary windings.

An advantage of the method and arrangement of the invention is that the measured secondary voltages can be corrected to take into account the parameters of the transformers, external wiring and/or burdens, for example. After the correction the secondary voltages better correspond to the true primary voltages. The invention does not require any changes to the transformer structure itself.

BRIEF DESCRIPTION OF THE DRAWINGS

In the following the invention will be described in greater detail by means of preferred embodiments with reference to the accompanying drawings, in which

Figure 1 shows a terminal diagram of a single pole insulated voltage transformer with three windings;
Figure 2 shows a principal construction of a single pole insulated voltage transformer with three windings;
Figure 3 shows a configuration of three single pole insulated voltage transformers each with three windings;
Figure 4 shows an equivalent circuit of three single pole instrument voltage transformers where secondary burden is star-connected;
Figure 5 shows an equivalent circuit of three single pole instrument voltage transformers where secondary burden is delta-connected (after delta-star conversion);
Figure 6 shows an equivalent circuit of three single pole instrument voltage transformers where secondary burden is star-connected;
Figure 7 shows an equivalent circuit of three single pole instrument voltage transformers where secondary burden is delta-connected (after delta-star conversion);
Figure 8 shows an apparatus according to an embodiment of the invention; and
Figure 9 shows an apparatus according to an embodiment of the invention.

DETAILED DESCRIPTION OF THE INVENTION

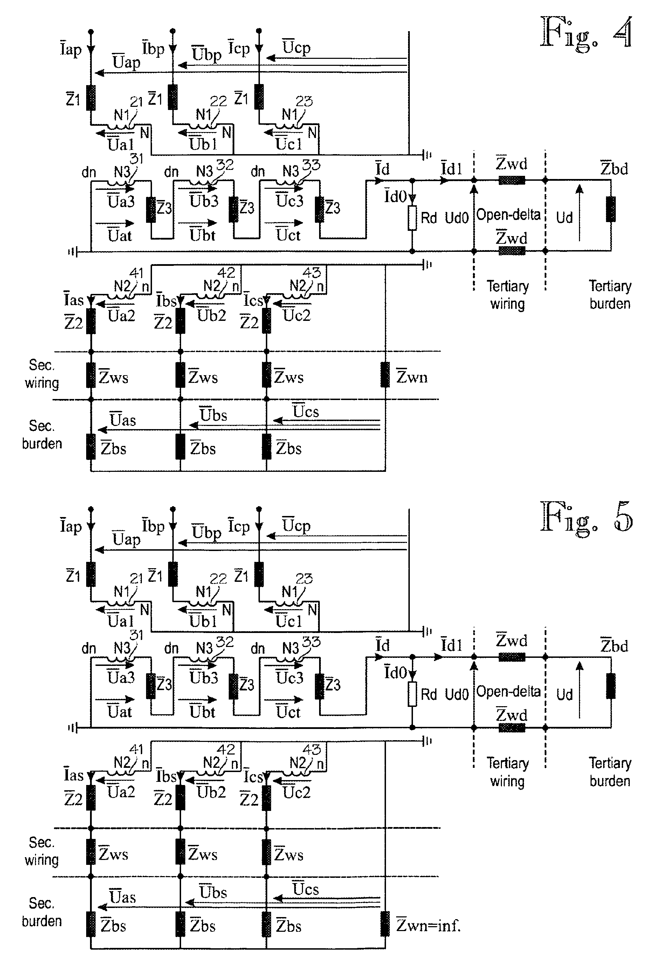

The application of the invention is not limited to any specific system, but it can be used in connection with various electric systems. Moreover, the use of the invention is not limited to systems or devices employing any specific fundamental frequency or any specific voltage level.
According to an embodiment, secondary voltages are measured from the secondary windings 41, 42, 43 and values of the primary voltages are determined on the basis of the measured secondary voltages. The determining of the values of the primary voltages then preferably comprises applying a correction to the measured secondary voltages on the basis of one or more parameters of the voltage transformers and/or one or more quantities in a known relation to one or more parameters of the voltage transformers, one or more parameters of a circuit connected to the secondary windings and/or one or more quantities in a known relation to one or more parameters of the circuit connected to the secondary windings, and one or more parameters of a circuit connected to the tertiary windings and/or one or more quantities in a known relation to one or more parameters of the circuit connected to the tertiary windings.
In order to analyze the behavior of an exemplary configuration of three single pole insulated voltage transformers with three windings in a three-phase network, the electrical equivalent schemes of Figures 4 and 5 can be derived.
The secondary burden (impedance $\overline{Z}bs$) is connected to the transformers' secondary (measuring) winding 41, 42, 43 terminals. The connection is made through wiring impedance $\overline{Z}ws$. Figure 4 illustrates a star-connected burden, where the common neutral conductor is modeled with wiring impedance $\overline{Z}wn$. The equivalent scheme presented in Figure 5 can be used in case the burden is delta connected. In this case the neutral conductor impedance $\overline{Z}wn$ equals infinity. $\overline{Z}bs$ values can be obtained using delta-star conversion for impedances.
The tertiary (earth-fault) windings 31, 32, 33 are connected in "open-delta" configuration for earth fault protection purposes. Resistor Rd is connected between open-delta terminals in order to prevent ferro-resonance. Tertiary burden (impedance $\overline{Z}bd$) is connected to transformers' tertiary terminals. The connection is made through wiring impedance $\overline{Z}wd$.
Notations used in Figures 4 and 5:

$\overline{U}ap$ = Phase PA primary phase-to-earth voltage
$\overline{U}bp$ = Phase PB primary phase-to-earth voltage
$\overline{U}cp$ = Phase PC primary phase-to-earth voltage
$\overline{U}as$ = Phase PA secondary phase-to-earth voltage
$\overline{U}bs$ = Phase PB secondary phase-to-earth voltage
$\overline{U}cs$ = Phase PC secondary phase-to-earth voltage
$\overline{U}at$ = Phase PA tertiary phase-to-earth voltage
$\overline{U}bt$ = Phase PB tertiary phase-to-earth voltage
$\overline{U}ct$ = Phase PC tertiary phase-to-earth voltage
$\overline{Z}1$ = Impedance of the primary winding
$\overline{Z}2$ = Impedance of the secondary winding
$\overline{Z}3$ = Impedance of the tertiary winding
$\overline{Z}ws$ = Secondary wiring impedance
$\overline{Z}wn$ = Wiring impedance of the neutral conductor of the secondary burden

$\overline{Z}$wd = Tertiary wiring impedance
$\overline{Z}$bs = Secondary burden impedance
$\overline{Z}$bd = Tertiary burden impedance
Rd = Ferro-resonance damping resistance
N1 = Number of turns of wire in the primary winding
N2 = Number of turns of wire in the secondary winding
N3 = Number of turns of wire in the tertiary winding
$\overline{I}$ap = Phase PA primary phase current
$\overline{I}$bp = Phase PB primary phase current
$\overline{I}$cp = Phase PC primary phase current
$\overline{I}$as = Phase PA secondary phase current
$\overline{I}$bs = Phase PB secondary phase current
$\overline{I}$cs = Phase PC secondary phase current
$\overline{U}$a1 = Voltage over the primary winding, phase PA
$\overline{U}$b1 = Voltage over the primary winding, phase PB
$\overline{U}$c1 = Voltage over the primary winding, phase PC
$\overline{U}$a2 = Voltage over the secondary winding, phase PA
$\overline{U}$b2 = Voltage over the secondary winding, phase PB
$\overline{U}$c2 = Voltage over the secondary winding, phase PC
$\overline{U}$a3 = Voltage over the tertiary winding, phase PA
$\overline{U}$b3 = Voltage over the tertiary winding, phase PB
$\overline{U}$c3 = Voltage over the tertiary winding, phase PC
$\overline{I}$d0 = Tertiary current through the damping resistor
$\overline{I}$d1 = Tertiary current through the tertiary burden
$\overline{I}$d = Total tertiary current
$\overline{U}$d = Open-delta voltage
$\overline{U}$d0 = Voltage over the damping resistor = $\overline{U}$at + $\overline{U}$bt + $\overline{U}$ct

The transformers are modeled with their respective longitudinal impedances $\overline{Z}$1, $\overline{Z}$2 and $\overline{Z}$3, which include a winding resistance and a leakage reactance. These are assumed to be similar for each phase transformer. Values for $\overline{Z}$1, $\overline{Z}$2 and $\overline{Z}$3 can be derived from short-circuit test results or obtained from the manufacturer of the transformer, for example. The effect of an external cabling/wiring for instrumentation can be taken into account by wiring impedances $\overline{Z}$ws, $\overline{Z}$wn and $\overline{Z}$wd. Burden can be taken into account with impedances $\overline{Z}$bs and $\overline{Z}$bd. From Figures 4 and 5, the following equations can be written (equations with "a" apply for Figure 4, equations with "b" apply for Figure 5):

Phase a:

$$\overline{U}ap - \overline{Z}1 * \overline{I}ap = \overline{U}a1 \qquad\qquad\qquad \text{(eq 1)}$$

$$\overline{U}a2 - (\overline{Z}2 + \overline{Z}ws) * \overline{I}as = \overline{U}as + \overline{Z}wn * (\overline{I}as + \overline{I}bs + \overline{I}cs) \quad \text{(eq 2a)}$$

$$\overline{U}a2 - (\overline{Z}2 + \overline{Z}ws) * \overline{I}as = \overline{U}as \qquad\qquad\qquad \text{(eq 2b)}$$

$$\overline{U}a3 - \overline{Z}3 * \overline{I}d = \overline{U}at \qquad\qquad\qquad \text{(eq 3)}$$

$$N1 * \overline{I}ap = N2 * \overline{I}as + N3 * \overline{I}d \qquad\qquad \text{(eq 4)}$$

$$\overline{U}as = \overline{Z}bs * \overline{I}as \qquad\qquad\qquad \text{(eq 5a)}$$

$$\overline{U}as = \overline{Z}bs * \overline{I}as + \overline{Z}wn * (\overline{I}as + \overline{I}bs + \overline{I}cs) \qquad \text{(eq 5b)}$$

$$\overline{U}a2 = (N2 / N1) * \overline{U}a1 \qquad \text{(eq 6)}$$

$$\overline{U}a3 = (N3 / N1) * \overline{U}a1 \qquad \text{(eq 7)}$$

Phase b:

$$\overline{U}bp - \overline{Z}1 * \overline{I}bp = \overline{U}b1 \qquad \text{(eq 8)}$$

$$\overline{U}b2 - (\overline{Z}2 + \overline{Z}ws) * \overline{I}bs = \overline{U}bs + \overline{Z}wn * (\overline{I}as + \overline{I}bs + \overline{I}cs) \qquad \text{(eq 9a)}$$

$$\overline{U}b2 - (\overline{Z}2 + \overline{Z}ws) * \overline{I}bs = \overline{U}bs \qquad \text{(eq 9b)}$$

$$\overline{U}b3 - \overline{Z}3 * \overline{I}d = \overline{U}bt \qquad \text{(eq 10)}$$

$$N1 * \overline{I}bp = N2 * \overline{I}bs + N3 * \overline{I}d \qquad \text{(eq 11)}$$

$$\overline{U}bs = \overline{Z}bs * \overline{I}bs \qquad \text{(eq 12a)}$$

$$\overline{U}bs = \overline{Z}bs * \overline{I}bs + \overline{Z}wn * (\overline{I}as + \overline{I}bs + \overline{I}cs) \qquad \text{(eq 12b)}$$

$$\overline{U}b2 = (N2 / N1) * \overline{U}b1 \qquad \text{(eq 13)}$$

$$\overline{U}b3 = (N3 / N1) * \overline{U}b1 \qquad \text{(eq 14)}$$

Phase c:

$$\overline{U}cp - \overline{Z}1 * \overline{I}cp = \overline{U}c1 \qquad \text{(eq 15)}$$

$$\overline{U}c2 - (\overline{Z}2 + \overline{Z}ws) * \overline{I}cs = \overline{U}cs + \overline{Z}wn * (\overline{I}as + \overline{I}bs + \overline{I}cs) \qquad \text{(eq 16a)}$$

$$\overline{Uc2} - (\overline{Z2} + \overline{Zws}) * \overline{Ics} = \overline{Ucs} \qquad \text{(eq 16b)}$$

$$\overline{Uc3} - \overline{Z3} * \overline{Id} = \overline{Uct} \qquad \text{(eq 17)}$$

$$N1 * \overline{Icp} = N2 * \overline{Ics} + N3 * \overline{Id} \qquad \text{(eq 18)}$$

$$\overline{Ucs} = \overline{Zbs} * \overline{Ics} \qquad \text{(eq 19a)}$$

$$\overline{Ucs} = \overline{Zbs} * \overline{Ics} + \overline{Zwn} * (\overline{Ias} + \overline{Ibs} + \overline{Ics}) \qquad \text{(eq 19b)}$$

$$\overline{Uc2} = (N2 / N1) * \overline{Uc1} \qquad \text{(eq 20)}$$

$$\overline{Uc3} = (N3 / N1) * \overline{Uc1} \qquad \text{(eq 21)}$$

And

$$\overline{Id0} * Rd = (\overline{Uat} + \overline{Ubt} + \overline{Uct}) \qquad \text{(eq 22)}$$

$$\overline{Id0} * Rd - \overline{Zwd} * \overline{Id1} = (\overline{Zbd} + \overline{Zwd}) * \overline{Id1} \qquad \text{(eq 23)}$$

$$\overline{Id} = \overline{Id0} + \overline{Id1} \qquad \text{(eq 24)}$$

In equations 1 to 24 the known voltages are assumed to be:

$\overline{U}as$ = Phase PA secondary phase-to-earth voltage
$\overline{U}bs$ = Phase PB secondary phase-to-earth voltage
$\overline{U}cs$ = Phase PC secondary phase-to-earth voltage

The known impedances and transformer-related values are:

$\overline{Z}1$ = Impedance of the primary winding
$\overline{Z}2$ = Impedance of the secondary winding
$\overline{Z}3$ = Impedance of the tertiary winding
$\overline{Z}ws$ = Wiring impedance of the secondary circuit
$\overline{Z}wn$ = Wiring impedance of the secondary circuit, neutral conductor
$\overline{Z}wd$ = Wiring impedance of the open delta
$\overline{Z}bs$ = Secondary burden impedance
$\overline{Z}bd$ = Tertiary burden impedance
Rd = Ferro-resonance damping resistance
N1 = Number of turns of wire in the primary winding
N2 = Number of turns of wire in the secondary winding
N3 = Number of turns of wire in the tertiary winding

All other voltages and currents can be calculated as a function of secondary phase-to-earth voltage and known impedances and transformer-related values. Thus, accurate primary phase-to-earth voltages can be obtained:

In case the secondary burden is star-connected and the common neutral conductor wiring impedance is $\overline{Z}wn$ (refer to Figure 4), equations 25-27 apply:

$$(\text{Eq. 25}) \ \overline{U}ap =$$

$1/N2/\overline{Z}bs*(3*N1^{2}*\overline{Z}wn*\overline{U}as*Rd*\overline{Z}3+6*N1^{2}*\overline{Z}wn*\overline{U}as*\overline{Z}3*\overline{Z}wd+$
$3*N1^{2}*\overline{Z}wn*\overline{U}as*\overline{Z}3*\overline{Z}bd+2*N1^{2}*\overline{Z}wn*\overline{U}as*Rd*\overline{Z}wd+N1^{2}*\overline{Z}wn*\overline{U}as*Rd*\overline{Z}bd+$
$3*N1^{2}*\overline{Z}wn*\overline{U}bs*Rd*\overline{Z}3+6*N1^{2}*\overline{Z}wn*\overline{U}bs*\overline{Z}3*\overline{Z}wd+$

$3*N1^{2}*\overline{Z}wn*\overline{U}bs*\overline{Z}3*\overline{Z}bd+2*N1^{2}*\overline{Z}wn*\overline{U}bs*Rd*\overline{Z}wd+N1^{2}*\overline{Z}wn*\overline{U}bs*Rd*\overline{Z}bd+$
$3*N1^{2}*\overline{Z}wn*\overline{U}cs*Rd*\overline{Z}3+6*N1^{2}*\overline{Z}wn*\overline{U}cs*\overline{Z}3*\overline{Z}wd3*N1^{2}*\overline{Z}wn*\overline{U}cs*\overline{Z}3*\overline{Z}bd+$
$2*N1^{2}*\overline{Z}wn*\overline{U}cs*Rd*\overline{Z}wd+N1^{2}*\overline{Z}wn*\overline{U}cs*Rd*\overline{Z}bd+2*\overline{Z}1*N3^{2}*\overline{Z}wd*\overline{U}bs*\overline{Z}bs+$
$3*\overline{Z}1*N3^{2}*\overline{Z}bd*\overline{Z}wn*\overline{U}bs+\overline{Z}1*N3^{2}*\overline{Z}bd*\overline{U}as*\overline{Z}ws+3*\overline{Z}1*N3^{2}*\overline{Z}bd*\overline{Z}wn*\overline{U}as+$
$\overline{Z}1*N3^{2}*\overline{Z}bd*\overline{U}as*\overline{Z}2+\overline{Z}1*N3^{2}*\overline{Z}bd*\overline{U}as*\overline{Z}bs+\overline{Z}1*N3^{2}*Rd*\overline{U}as*\overline{Z}bs+$
$6*\overline{Z}1*N3^{2}*\overline{Z}wd*\overline{Z}wn*\overline{U}cs+3*\overline{Z}1*N3^{2}*\overline{Z}bd*\overline{Z}wn*\overline{U}cs+\overline{Z}1*N3^{2}*\overline{Z}bd*\overline{U}bs*\overline{Z}2+$
$\overline{Z}1*N3^{2}*\overline{Z}bd*\overline{U}cs*\overline{Z}2+\overline{Z}1*N3^{2}*\overline{Z}bd*\overline{U}cs*\overline{Z}ws+\overline{Z}1*N3^{2}*\overline{Z}bd*\overline{U}cs*\overline{Z}bs+$
$\overline{Z}1*N3^{2}*\overline{Z}bd*\overline{U}bs*\overline{Z}ws+\overline{Z}1*N3^{2}*\overline{Z}bd*\overline{U}bs*\overline{Z}bs+\overline{Z}1*N3^{2}*Rd*\overline{U}as*\overline{Z}2+$
$\overline{Z}1*N3^{2}*Rd*\overline{U}as*\overline{Z}ws+3*\overline{Z}1*N3^{2}*Rd*\overline{Z}wn*\overline{U}as+3*\overline{Z}1*N3^{2}*Rd*\overline{Z}wn*\overline{U}bs+$
$3*\overline{Z}1*N3^{2}*Rd*\overline{Z}wn*\overline{U}cs+\overline{Z}1*N3^{2}*Rd*\overline{U}bs*\overline{Z}2+\overline{Z}1*N3^{2}*Rd*\overline{U}cs*\overline{Z}2+$
$\overline{Z}1*N3^{2}*Rd*\overline{U}cs*\overline{Z}ws+\overline{Z}1*N3^{2}*Rd*\overline{U}cs*\overline{Z}bs+\overline{Z}1*N3^{2}*Rd*\overline{U}bs*\overline{Z}ws+$
$\overline{Z}1*N3^{2}*Rd*\overline{U}bs*\overline{Z}bs+2*\overline{Z}1*N3^{2}*\overline{Z}wd*\overline{U}as*\overline{Z}2+2*\overline{Z}1*N3^{2}*\overline{Z}wd*\overline{U}as*\overline{Z}ws+$
$2*\overline{Z}1*N3^{2}*\overline{Z}wd*\overline{U}as*\overline{Z}bs+6*\overline{Z}1*N3^{2}*\overline{Z}wd*\overline{Z}wn*\overline{U}as+$
$6*\overline{Z}1*N3^{2}*\overline{Z}wd*\overline{Z}wn*\overline{U}bs+2*\overline{Z}1*N3^{2}*\overline{Z}wd*\overline{U}bs*\overline{Z}2+$
$2*\overline{Z}1*N3^{2}*\overline{Z}wd*\overline{U}cs*\overline{Z}ws+2*\overline{Z}1*N3^{2}*\overline{Z}wd*\overline{U}cs*\overline{Z}bs+$
$2*\overline{Z}1*N3^{2}*\overline{Z}wd*\overline{U}bs*\overline{Z}ws+2*\overline{Z}1*N3^{2}*\overline{Z}wd*\overline{U}cs*\overline{Z}2+3*N1^{2}*\overline{U}as*\overline{Z}2*Rd*\overline{Z}3+$
$6*N1^{2}*\overline{U}as*\overline{Z}2*\overline{Z}3*\overline{Z}wd+3*N1^{2}*\overline{U}as*\overline{Z}2*\overline{Z}3*\overline{Z}bd+2*N1^{2}*\overline{U}as*\overline{Z}2*Rd*\overline{Z}wd+$
$N1^{2}*\overline{U}as*\overline{Z}2*Rd*\overline{Z}bd+3*N1^{2}*\overline{U}as*\overline{Z}ws*Rd*\overline{Z}3+6*N1^{2}*\overline{U}as*\overline{Z}ws*\overline{Z}3*\overline{Z}wd+$
$3*N1^{2}*\overline{U}as*\overline{Z}ws*\overline{Z}3*\overline{Z}bd+2*N1^{2}*\overline{U}as*\overline{Z}ws*Rd*\overline{Z}wd+N1^{2}*\overline{U}as*\overline{Z}ws*Rd*\overline{Z}bd+$
$3*N1^{2}*\overline{U}as*\overline{Z}bs*Rd*\overline{Z}3+6*N1^{2}*\overline{U}as*\overline{Z}bs*\overline{Z}3*\overline{Z}wd+3*N1^{2}*\overline{U}as*\overline{Z}bs*\overline{Z}3*\overline{Z}bd+$
$2*N1^{2}*\overline{U}as*\overline{Z}bs*Rd*\overline{Z}wd+N1^{2}*\overline{U}as*\overline{Z}bs*Rd*\overline{Z}bd+3*\overline{Z}1*N2^{2}*\overline{U}as*Rd*\overline{Z}3+$
$6*\overline{Z}1*N2^{2}*\overline{U}as*\overline{Z}3*\overline{Z}wd+3*\overline{Z}1*N2^{2}*\overline{U}as*\overline{Z}3*\overline{Z}bd+2*\overline{Z}1*N2^{2}*\overline{U}as*Rd*\overline{Z}wd+$
$\overline{Z}1*N2^{2}*\overline{U}as*Rd*\overline{Z}bd)/N1/(3*Rd*\overline{Z}3+6*\overline{Z}3*\overline{Z}wd+3*\overline{Z}3*\overline{Z}bd+2*Rd*\overline{Z}wd+$
$Rd*\overline{Z}bd)$

(Eq. 26) $\overline{U}bp =$

$$1/N2/\overline{Z}bs*(3*N1^{2}*\overline{Z}wn*\overline{U}as*Rd*\overline{Z}3+6*N1^{2}*\overline{Z}wn*\overline{U}as*\overline{Z}3*\overline{Z}wd+$$
$$3*N1^{2}*\overline{Z}wn*\overline{U}as*\overline{Z}3*\overline{Z}bd+2*N1^{2}*\overline{Z}wn*\overline{U}as*Rd*\overline{Z}wd+N1^{2}*\overline{Z}wn*\overline{U}as*Rd*\overline{Z}bd+$$
$$3*N1^{2}*\overline{Z}wn*\overline{U}bs*Rd*\overline{Z}3+6*N1^{2}*\overline{Z}wn*\overline{U}bs*\overline{Z}3*\overline{Z}wd+$$
$$3*N1^{2}*\overline{Z}wn*\overline{U}bs*\overline{Z}3*\overline{Z}bd+2*N1^{2}*\overline{Z}wn*\overline{U}bs*Rd*\overline{Z}wd+N1^{2}*\overline{Z}wn*\overline{U}bs*Rd*\overline{Z}bd+$$
$$3*N1^{2}*\overline{Z}wn*\overline{U}cs*Rd*\overline{Z}3+6*N1^{2}*\overline{Z}wn*\overline{U}cs*\overline{Z}3*\overline{Z}wd+$$
$$3*N1^{2}*\overline{Z}wn*\overline{U}cs*\overline{Z}3*\overline{Z}bd+2*N1^{2}*\overline{Z}wn*\overline{U}cs*Rd*\overline{Z}wd+N1^{2}*\overline{Z}wn*\overline{U}cs*Rd*\overline{Z}bd+$$
$$2*\overline{Z}1*N3^{2}*\overline{Z}wd*\overline{U}bs*\overline{Z}bs+3*\overline{Z}1*N3^{2}*\overline{Z}bd*\overline{Z}wn*\overline{U}bs+\overline{Z}1*N3^{2}*\overline{Z}bd*\overline{U}as*\overline{Z}ws+$$
$$3*\overline{Z}1*N3^{2}*\overline{Z}bd*\overline{Z}wn*\overline{U}as+\overline{Z}1*N3^{2}*\overline{Z}bd*\overline{U}as*\overline{Z}2+\overline{Z}1*N3^{2}*\overline{Z}bd*\overline{U}as*\overline{Z}bs+$$
$$\overline{Z}1*N3^{2}*Rd*\overline{U}as*\overline{Z}bs+6*\overline{Z}1*N3^{2}*\overline{Z}wd*\overline{Z}wn*\overline{U}cs+3*\overline{Z}1*N3^{2}*\overline{Z}bd*\overline{Z}wn*\overline{U}cs+$$

$$\overline{Z}1*N3^{2}*\overline{Z}bd*\overline{U}bs*\overline{Z}2+\overline{Z}1*N3^{2}*\overline{Z}bd*\overline{U}cs*\overline{Z}2+\overline{Z}1*N3^{2}*\overline{Z}bd*\overline{U}cs*\overline{Z}ws+$$
$$\overline{Z}1*N3^{2}*\overline{Z}bd*\overline{U}cs*\overline{Z}bs+\overline{Z}1*N3^{2}*\overline{Z}bd*\overline{U}bs*\overline{Z}ws+\overline{Z}1*N3^{2}*\overline{Z}bd*\overline{U}bs*\overline{Z}bs+$$
$$\overline{Z}1*N3^{2}*Rd*\overline{U}as*\overline{Z}2+\overline{Z}1*N3^{2}*Rd*\overline{U}as*\overline{Z}ws+3*\overline{Z}1*N3^{2}*Rd*\overline{Z}wn*\overline{U}as+$$
$$3*\overline{Z}1*N3^{2}*Rd*\overline{Z}wn*\overline{U}bs+3*\overline{Z}1*N3^{2}*Rd*\overline{Z}wn*\overline{U}cs+\overline{Z}1*N3^{2}*Rd*\overline{U}bs*\overline{Z}2+$$
$$\overline{Z}1*N3^{2}*Rd*\overline{U}cs*\overline{Z}2+\overline{Z}1*N3^{2}*Rd*\overline{U}cs*\overline{Z}ws+\overline{Z}1*N3^{2}*Rd*\overline{U}cs*\overline{Z}bs+$$
$$\overline{Z}1*N3^{2}*Rd*\overline{U}bs*\overline{Z}ws+\overline{Z}1*N3^{2}*Rd*\overline{U}bs*\overline{Z}bs+2*\overline{Z}1*N3^{2}*\overline{Z}wd*\overline{U}as*\overline{Z}2+$$
$$2*\overline{Z}1*N3^{2}*\overline{Z}wd*\overline{U}as*\overline{Z}ws+2*\overline{Z}1*N3^{2}*\overline{Z}wd*\overline{U}as*\overline{Z}bs+$$
$$6*\overline{Z}1*N3^{2}*\overline{Z}wd*\overline{Z}wn*\overline{U}as+6*\overline{Z}1*N3^{2}*\overline{Z}wd*\overline{Z}wn*\overline{U}bs+$$
$$2*\overline{Z}1*N3^{2}*\overline{Z}wd*\overline{U}bs*\overline{Z}2+2*\overline{Z}1*N3^{2}*\overline{Z}wd*\overline{U}cs*\overline{Z}ws+$$
$$2*\overline{Z}1*N3^{2}*\overline{Z}wd*\overline{U}cs*\overline{Z}bs+2*\overline{Z}1*N3^{2}*\overline{Z}wd*\overline{U}bs*\overline{Z}ws+$$
$$2*\overline{Z}1*N3^{2}*\overline{Z}wd*\overline{U}cs*\overline{Z}2+3*N1^{2}*\overline{U}bs*\overline{Z}2*Rd*\overline{Z}3+6*N1^{2}*\overline{U}bs*\overline{Z}2*\overline{Z}3*\overline{Z}wd+$$
$$3*N1^{2}*\overline{U}bs*\overline{Z}2*\overline{Z}3*\overline{Z}bd+2*N1^{2}*\overline{U}bs*\overline{Z}2*Rd*\overline{Z}wd+N1^{2}*\overline{U}bs*\overline{Z}2*Rd*\overline{Z}bd+$$
$$3*N1^{2}*\overline{U}bs*\overline{Z}ws*Rd*\overline{Z}3+6*N1^{2}*\overline{U}bs*\overline{Z}ws*\overline{Z}3*\overline{Z}wd+$$
$$3*N1^{2}*\overline{U}bs*\overline{Z}ws*\overline{Z}3*\overline{Z}bd+2*N1^{2}*\overline{U}bs*\overline{Z}ws*Rd*\overline{Z}wd+N1^{2}*\overline{U}bs*\overline{Z}ws*Rd*\overline{Z}bd+$$
$$3*N1^{2}*\overline{U}bs*\overline{Z}bs*Rd*\overline{Z}3+6*N1^{2}*\overline{U}bs*\overline{Z}bs*\overline{Z}3*\overline{Z}wd+3*N1^{2}*\overline{U}bs*\overline{Z}bs*\overline{Z}3*\overline{Z}bd+$$
$$2*N1^{2}*\overline{U}bs*\overline{Z}bs*Rd*\overline{Z}wd+N1^{2}*\overline{U}bs*\overline{Z}bs*Rd*\overline{Z}bd+3*\overline{Z}1*N2^{2}*\overline{U}bs*Rd*\overline{Z}3+$$
$$6*\overline{Z}1*N2^{2}*\overline{U}bs*\overline{Z}3*\overline{Z}wd+3*\overline{Z}1*N2^{2}*\overline{U}bs*\overline{Z}3*\overline{Z}bd+2*\overline{Z}1*N2^{2}*\overline{U}bs*Rd*\overline{Z}wd+$$
$$\overline{Z}1*N2^{2}*\overline{U}bs*Rd*\overline{Z}bd)/N1/(3*Rd*\overline{Z}3+6*\overline{Z}3*\overline{Z}wd+3*\overline{Z}3*\overline{Z}bd+2*Rd*\overline{Z}wd+$$
$$Rd*\overline{Z}bd)$$

$$(\text{Eq. 27})\ \bar{U}cp =$$

$$1/N2/\bar{Z}bs*(3*N1^{2}*\bar{Z}wn*\bar{U}as*Rd*\bar{Z}3+6*N1^{2}*\bar{Z}wn*\bar{U}as*\bar{Z}3*\bar{Z}wd+$$

$$3*N1^{2}*\bar{Z}wn*\bar{U}as*\bar{Z}3*\bar{Z}bd+2*N1^{2}*\bar{Z}wn*\bar{U}as*Rd*\bar{Z}wd+N1^{2}*\bar{Z}wn*\bar{U}as*Rd*\bar{Z}bd+$$

$$3*N1^{2}*\bar{U}cs*\bar{Z}2*Rd*\bar{Z}3+6*N1^{2}*\bar{U}cs*\bar{Z}2*\bar{Z}3*\bar{Z}wd+3*N1^{2}*\bar{U}cs*\bar{Z}2*\bar{Z}3*\bar{Z}bd+$$

$$2*N1^{2}*\bar{U}cs*\bar{Z}2*Rd*\bar{Z}wd+N1^{2}*\bar{U}cs*\bar{Z}2*Rd*\bar{Z}bd+3*N1^{2}*\bar{U}cs*\bar{Z}ws*Rd*\bar{Z}3+$$

$$6*N1^{2}*\bar{U}cs*\bar{Z}ws*\bar{Z}3*\bar{Z}wd+3*N1^{2}*\bar{U}cs*\bar{Z}ws*\bar{Z}3*\bar{Z}bd+$$

$$2*N1^{2}*\bar{U}cs*\bar{Z}ws*Rd*\bar{Z}wd+N1^{2}*\bar{U}cs*\bar{Z}ws*Rd*\bar{Z}bd+3*N1^{2}*\bar{U}cs*\bar{Z}bs*Rd*\bar{Z}3+$$

$$6*N1^{2}*\bar{U}cs*\bar{Z}bs*\bar{Z}3*\bar{Z}wd+3*N1^{2}*\bar{U}cs*\bar{Z}bs*\bar{Z}3*\bar{Z}bd+$$

$$2*N1^{2}*\bar{U}cs*\bar{Z}bs*Rd*\bar{Z}wd+N1^{2}*\bar{U}cs*\bar{Z}bs*Rd*\bar{Z}bd+3*\bar{Z}1*N2^{2}*\bar{U}cs*Rd*\bar{Z}3+$$

$$6*\bar{Z}1*N2^{2}*\bar{U}cs*\bar{Z}3*\bar{Z}wd+3*\bar{Z}1*N2^{2}*\bar{U}cs*\bar{Z}3*\bar{Z}bd+2*\bar{Z}1*N2^{2}*\bar{U}cs*Rd*\bar{Z}wd+$$

$$\bar{Z}1*N2^{2}*\bar{U}cs*Rd*\bar{Z}bd+3*N1^{2}*\bar{Z}wn*\bar{U}bs*Rd*\bar{Z}3+6*N1^{2}*\bar{Z}wn*\bar{U}bs*\bar{Z}3*\bar{Z}wd+$$

$$3*N1^{2}*\bar{Z}wn*\bar{U}bs*\bar{Z}3*\bar{Z}bd+2*N1^{2}*\bar{Z}wn*\bar{U}bs*Rd*\bar{Z}wd+N1^{2}*\bar{Z}wn*\bar{U}bs*Rd*\bar{Z}bd+$$

$$3*N1^{2}*\bar{Z}wn*\bar{U}cs*Rd*\bar{Z}3+6*N1^{2}*\bar{Z}wn*\bar{U}cs*\bar{Z}3*\bar{Z}wd+$$

$$3*N1^{2}*\bar{Z}wn*\bar{U}cs*\bar{Z}3*\bar{Z}bd+2*N1^{2}*\bar{Z}wn*\bar{U}cs*Rd*\bar{Z}wd+N1^{2}*\bar{Z}wn*\bar{U}cs*Rd*\bar{Z}bd+$$

$$2*\bar{Z}1*N3^{2}*\bar{Z}wd*\bar{U}bs*\bar{Z}bs+3*\bar{Z}1*N3^{2}*\bar{Z}bd*\bar{Z}wn*\bar{U}bs+\bar{Z}1*N3^{2}*\bar{Z}bd*\bar{U}as*\bar{Z}ws+$$

$$3*\bar{Z}1*N3^{2}*\bar{Z}bd*\bar{Z}wn*\bar{U}as+\bar{Z}1*N3^{2}*\bar{Z}bd*\bar{U}as*\bar{Z}2+\bar{Z}1*N3^{2}*\bar{Z}bd*\bar{U}as*\bar{Z}bs+$$

$$\bar{Z}1*N3^{2}*Rd*\bar{U}as*\bar{Z}bs+6*\bar{Z}1*N3^{2}*\bar{Z}wd*\bar{Z}wn*\bar{U}cs+3*\bar{Z}1*N3^{2}*\bar{Z}bd*\bar{Z}wn*\bar{U}cs+$$

$$\bar{Z}1*N3^{2}*\bar{Z}bd*\bar{U}bs*\bar{Z}2+\bar{Z}1*N3^{2}*\bar{Z}bd*\bar{U}cs*\bar{Z}2+\bar{Z}1*N3^{2}*\bar{Z}bd*\bar{U}cs*\bar{Z}ws+$$

$$\bar{Z}1*N3^{2}*\bar{Z}bd*\bar{U}cs*\bar{Z}bs+\bar{Z}1*N3^{2}*\bar{Z}bd*\bar{U}bs*\bar{Z}ws+\bar{Z}1*N3^{2}*\bar{Z}bd*\bar{U}bs*\bar{Z}bs+$$

$$\bar{Z}1*N3^{2}*Rd*\bar{U}as*\bar{Z}2+\bar{Z}1*N3^{2}*Rd*\bar{U}as*\bar{Z}ws+3*\bar{Z}1*N3^{2}*Rd*\bar{Z}wn*\bar{U}as+$$

$$3*\bar{Z}1*N3^{2}*Rd*\bar{Z}wn*\bar{U}bs+3*\bar{Z}1*N3^{2}*Rd*\bar{Z}wn*\bar{U}cs+\bar{Z}1*N3^{2}*Rd*\bar{U}bs*\bar{Z}2+$$

$$\bar{Z}1*N3^{2}*Rd*\bar{U}cs*\bar{Z}2+\bar{Z}1*N3^{2}*Rd*\bar{U}cs*\bar{Z}ws+\bar{Z}1*N3^{2}*Rd*\bar{U}cs*\bar{Z}bs+$$

$$\bar{Z}1*N3^{2}*Rd*\bar{U}bs*\bar{Z}ws+\bar{Z}1*N3^{2}*Rd*\bar{U}bs*\bar{Z}bs+2*\bar{Z}1*N3^{2}*\bar{Z}wd*\bar{U}as*\bar{Z}2+$$

$$2*\bar{Z}1*N3^{2}*\bar{Z}wd*\bar{U}as*\bar{Z}ws+2*\bar{Z}1*N3^{2}*\bar{Z}wd*\bar{U}as*\bar{Z}bs+$$

$$6*\bar{Z}1*N3^{2}*\bar{Z}wd*\bar{Z}wn*\bar{U}as+6*\bar{Z}1*N3^{2}*\bar{Z}wd*\bar{Z}wn*\bar{U}bs+$$

$$2*\bar{Z}1*N3^{2}*\bar{Z}wd*\bar{U}bs*\bar{Z}2+2*\bar{Z}1*N3^{2}*\bar{Z}wd*\bar{U}cs*\bar{Z}ws+$$

$$2*\bar{Z}1*N3^{2}*\bar{Z}wd*\bar{U}cs*\bar{Z}bs+2*\bar{Z}1*N3^{2}*\bar{Z}wd*\bar{U}bs*\bar{Z}ws+$$

$$2*\bar{Z}1*N3^{2}*\bar{Z}wd*\bar{U}cs*\bar{Z}2)/N1/(3*Rd*\bar{Z}3+6*\bar{Z}3*\bar{Z}wd+3*\bar{Z}3*\bar{Z}bd+2*Rd*\bar{Z}wd+$$

$$Rd*\bar{Z}bd)$$

In case the secondary burden is delta connected, the equivalent scheme of Figure 5 can be utilized. The neutral conductor impedance $\bar{Z}wn$ equals then infinity. $\bar{Z}bs$ values can be obtained using delta-star conversion for impedances. Equations 28-30 apply:

$$(\text{Eq. 28})\ \bar{U}ap =$$

$$
\begin{aligned}
&1/3*(-3*N1^{2}*\bar{Z}3*Rd*\bar{Z}ws*\bar{U}cs+6*N1^{2}*\bar{Z}3*Rd*\bar{Z}2*\bar{U}as-3*N1^{2}*\bar{Z}3*Rd*\bar{Z}2*\bar{U}bs- \\
&3*N1^{2}*\bar{Z}3*\bar{Z}bd*\bar{Z}2*\bar{U}bs-3*N1^{2}*\bar{Z}3*\bar{Z}bd*\bar{Z}ws*\bar{U}cs-6*N1^{2}*\bar{Z}3*\bar{Z}wd*\bar{Z}2*\bar{U}cs+ \\
&12*N1^{2}*\bar{Z}3*\bar{Z}wd*\bar{Z}ws*\bar{U}as-6*N1^{2}*\bar{Z}3*\bar{Z}wd*\bar{Z}ws*\bar{U}bs+ \\
&6*N1^{2}*\bar{Z}3*\bar{Z}bd*\bar{Z}2*\bar{U}as+3*\bar{Z}bs*\bar{Z}1*N3^{2}*\bar{Z}bd*\bar{U}as+6*N1^{2}*\bar{Z}3*Rd*\bar{Z}ws*\bar{U}as- \\
&3*N1^{2}*\bar{Z}3*Rd*\bar{Z}ws*\bar{U}bs-N1^{2}*\bar{Z}2*\bar{U}cs*Rd*\bar{Z}bd-2*N1^{2}*\bar{Z}2*\bar{U}cs*Rd*\bar{Z}wd+ \\
&3*\bar{Z}bs*\bar{Z}1*N3^{2}*\bar{Z}bd*\bar{U}bs+6*\bar{Z}bs*\bar{Z}1*N3^{2}*\bar{Z}wd*\bar{U}cs+ \\
&6*\bar{Z}bs*\bar{Z}1*N3^{2}*\bar{Z}wd*\bar{U}as-3*N1^{2}*\bar{Z}3*Rd*\bar{Z}2*\bar{U}cs+6*\bar{Z}bs*\bar{Z}1*N3^{2}*\bar{Z}wd*\bar{U}bs+ \\
&3*\bar{Z}bs*\bar{Z}1*N3^{2}*Rd*\bar{U}cs+3*\bar{Z}bs*\bar{Z}1*N3^{2}*\bar{Z}bd*\bar{U}cs+3*\bar{Z}bs*\bar{Z}1*N3^{2}*Rd*\bar{U}bs+ \\
&3*\bar{Z}bs*\bar{Z}1*N3^{2}*Rd*\bar{U}as+18*\bar{Z}bs*N1^{2}*\bar{Z}3*\bar{Z}wd*\bar{U}as+3*\bar{Z}bs*N1^{2}*\bar{U}as*Rd*\bar{Z}bd- \\
&6*N1^{2}*\bar{Z}3*\bar{Z}wd*\bar{Z}ws*\bar{U}cs+6*\bar{Z}bs*N1^{2}*\bar{U}as*Rd*\bar{Z}wd+9*\bar{Z}bs*N1^{2}*\bar{Z}3*Rd*\bar{U}as+ \\
&9*\bar{Z}bs*N1^{2}*\bar{Z}3*\bar{Z}bd*\bar{U}as-3*\bar{Z}1*N2^{2}*\bar{U}cs*Rd*\bar{Z}3+12*\bar{Z}1*N2^{2}*\bar{U}as*\bar{Z}wd*\bar{Z}3- \\
&3*\bar{Z}1*N2^{2}*\bar{U}cs*\bar{Z}bd*\bar{Z}3-6*\bar{Z}1*N2^{2}*\bar{U}cs*\bar{Z}wd*\bar{Z}3+2*\bar{Z}1*N2^{2}*\bar{U}as*Rd*\bar{Z}bd+
\end{aligned}
$$

$$
\begin{aligned}
&4*\bar{Z}1*N2^{2}*\bar{U}as*Rd*\bar{Z}wd+6*\bar{Z}1*N2^{2}*\bar{U}as*\bar{Z}bd*\bar{Z}3-\bar{Z}1*N2^{2}*\bar{U}cs*Rd*\bar{Z}bd- \\
&2*\bar{Z}1*N2^{2}*\bar{U}cs*Rd*\bar{Z}wd-3*\bar{Z}1*N2^{2}*\bar{U}bs*Rd*\bar{Z}3-N1^{2}*\bar{Z}ws*\bar{U}bs*Rd*\bar{Z}bd- \\
&6*N1^{2}*\bar{Z}3*\bar{Z}wd*\bar{Z}2*\bar{U}bs-2*N1^{2}*\bar{Z}ws*\bar{U}bs*Rd*\bar{Z}wd+6*\bar{Z}1*N2^{2}*\bar{U}as*Rd*\bar{Z}3+ \\
&12*N1^{2}*\bar{Z}3*\bar{Z}wd*\bar{Z}2*\bar{U}as-6*\bar{Z}1*N2^{2}*\bar{U}bs*\bar{Z}wd*\bar{Z}3-2*\bar{Z}1*N2^{2}*\bar{U}bs*Rd*\bar{Z}wd- \\
&3*\bar{Z}1*N2^{2}*\bar{U}bs*\bar{Z}bd*\bar{Z}3-2*N1^{2}*\bar{Z}ws*\bar{U}cs*Rd*\bar{Z}wd+2*N1^{2}*\bar{Z}2*\bar{U}as*Rd*\bar{Z}bd+ \\
&4*N1^{2}*\bar{Z}2*\bar{U}as*Rd*\bar{Z}wd-\bar{Z}1*N2^{2}*\bar{U}bs*Rd*\bar{Z}bd-N1^{2}*\bar{Z}ws*\bar{U}cs*Rd*\bar{Z}bd- \\
&3*N1^{2}*\bar{Z}3*\bar{Z}bd*\bar{Z}ws*\bar{U}bs-N1^{2}*\bar{Z}2*\bar{U}bs*Rd*\bar{Z}bd-2*N1^{2}*\bar{Z}2*\bar{U}bs*Rd*\bar{Z}wd+ \\
&2*N1^{2}*\bar{Z}ws*\bar{U}as*Rd*\bar{Z}bd+4*N1^{2}*\bar{Z}ws*\bar{U}as*Rd*\bar{Z}wd-3*N1^{2}*\bar{Z}3*\bar{Z}bd*\bar{Z}2*\bar{U}cs+ \\
&6*N1^{2}*\bar{Z}3*\bar{Z}bd*\bar{Z}ws*\bar{U}as)/N1/\bar{Z}bs/N2/(6*\bar{Z}wd*\bar{Z}3+3*\bar{Z}bd*\bar{Z}3+2*Rd*\bar{Z}wd+ \\
&Rd*\bar{Z}bd+3*Rd*\bar{Z}3)
\end{aligned}
$$

$$(\text{Eq. 29}) \quad \bar{U}bp =$$

$-1/3*(3*N1^{2}*\bar{Z}3*Rd*\bar{Z}ws*\bar{U}cs+3*N1^{2}*\bar{Z}3*Rd*\bar{Z}2*\bar{U}as-6*N1^{2}*\bar{Z}3*Rd*\bar{Z}2*\bar{U}bs-$
$6*N1^{2}*\bar{Z}3*\bar{Z}bd*\bar{Z}2*\bar{U}bs+3*N1^{2}*\bar{Z}3*\bar{Z}bd*\bar{Z}ws*\bar{U}cs+6*N1^{2}*\bar{Z}3*\bar{Z}wd*\bar{Z}2*\bar{U}cs+$
$6*N1^{2}*\bar{Z}3*\bar{Z}wd*\bar{Z}ws*\bar{U}as-12*N1^{2}*\bar{Z}3*\bar{Z}wd*\bar{Z}ws*\bar{U}bs+$
$3*N1^{2}*\bar{Z}3*\bar{Z}bd*\bar{Z}2*\bar{U}as-3*\bar{Z}bs*\bar{Z}1*N3^{2}*\bar{Z}bd*\bar{U}as+3*N1^{2}*\bar{Z}3*Rd*\bar{Z}ws*\bar{U}as-$
$6*N1^{2}*\bar{Z}3*Rd*\bar{Z}ws*\bar{U}bs+N1^{2}*\bar{Z}2*\bar{U}cs*Rd*\bar{Z}bd+2*N1^{2}*\bar{Z}2*\bar{U}cs*Rd*\bar{Z}wd-$
$3*\bar{Z}bs*\bar{Z}1*N3^{2}*\bar{Z}bd*\bar{U}bs-6*\bar{Z}bs*\bar{Z}1*N3^{2}*\bar{Z}wd*\bar{U}cs-6*\bar{Z}bs*\bar{Z}1*N3^{2}*\bar{Z}wd*\bar{U}as+$
$3*N1^{2}*\bar{Z}3*Rd*\bar{Z}2*\bar{U}cs-6*\bar{Z}bs*\bar{Z}1*N3^{2}*\bar{Z}wd*\bar{U}bs-3*\bar{Z}bs*\bar{Z}1*N3^{2}*Rd*\bar{U}cs-$
$3*\bar{Z}bs*\bar{Z}1*N3^{2}*\bar{Z}bd*\bar{U}cs-3*\bar{Z}bs*\bar{Z}1*N3^{2}*Rd*\bar{U}bs-3*\bar{Z}bs*\bar{Z}1*N3^{2}*Rd*\bar{U}as+$
$6*N1^{2}*\bar{Z}3*\bar{Z}wd*\bar{Z}ws*\bar{U}cs+3*\bar{Z}1*N2^{2}*\bar{U}cs*Rd*\bar{Z}3+6*\bar{Z}1*N2^{2}*\bar{U}as*\bar{Z}wd*\bar{Z}3+$
$3*\bar{Z}1*N2^{2}*\bar{U}cs*\bar{Z}bd*\bar{Z}3+6*\bar{Z}1*N2^{2}*\bar{U}cs*\bar{Z}wd*\bar{Z}3+\bar{Z}1*N2^{2}*\bar{U}as*Rd*\bar{Z}bd+$
$2*\bar{Z}1*N2^{2}*\bar{U}as*Rd*\bar{Z}wd+3*\bar{Z}1*N2^{2}*\bar{U}as*\bar{Z}bd*\bar{Z}3+\bar{Z}1*N2^{2}*\bar{U}cs*Rd*\bar{Z}bd+$
$2*\bar{Z}1*N2^{2}*\bar{U}cs*Rd*\bar{Z}wd-6*\bar{Z}1*N2^{2}*\bar{U}bs*Rd*\bar{Z}3-2*N1^{2}*\bar{Z}ws*\bar{U}bs*Rd*\bar{Z}bd-$
$12*N1^{2}*\bar{Z}3*\bar{Z}wd*\bar{Z}2*\bar{U}bs-4*N1^{2}*\bar{Z}ws*\bar{U}bs*Rd*\bar{Z}wd +3*\bar{Z}1*N2^{2}*\bar{U}as*Rd*\bar{Z}3+$
$6*N1^{2}*\bar{Z}3*\bar{Z}wd*\bar{Z}2*\bar{U}as-12*\bar{Z}1*N2^{2}*\bar{U}bs*\bar{Z}wd*\bar{Z}3-4*\bar{Z}1*N2^{2}*\bar{U}bs*Rd*\bar{Z}wd-$
$6*\bar{Z}1*N2^{2}*\bar{U}bs*\bar{Z}bd*\bar{Z}3+2*N1^{2}*\bar{Z}ws*\bar{U}cs*Rd*\bar{Z}wd+N1^{2}*\bar{Z}2*\bar{U}as*Rd*\bar{Z}bd+$
$2*N1^{2}*\bar{Z}2*\bar{U}as*Rd*\bar{Z}wd-2*\bar{Z}1*N2^{2}*\bar{U}bs*Rd*\bar{Z}bd-9*N1^{2}*\bar{Z}bs*\bar{Z}3*Rd*\bar{U}bs-$
$9*N1^{2}*\bar{Z}bs*\bar{Z}3*\bar{Z}bd*\bar{U}bs-6*N1^{2}*\bar{U}bs*\bar{Z}bs*Rd*\bar{Z}wd-3*N1^{2}*\bar{U}bs*\bar{Z}bs*Rd*\bar{Z}bd-$
$18*N1^{2}*\bar{Z}bs*\bar{Z}3*\bar{Z}wd*\bar{U}bs+N1^{2}*\bar{Z}ws*\bar{U}cs*Rd*\bar{Z}bd-6*N1^{2}*\bar{Z}3*\bar{Z}bd*\bar{Z}ws*\bar{U}bs-$
$2*N1^{2}*\bar{Z}2*\bar{U}bs*Rd*\bar{Z}bd-4*N1^{2}*\bar{Z}2*\bar{U}bs*Rd*\bar{Z}wd+N1^{2}*\bar{Z}ws*\bar{U}as*Rd*\bar{Z}bd+$
$2*N1^{2}*\bar{Z}ws*\bar{U}as*Rd*\bar{Z}wd+3*N1^{2}*\bar{Z}3*\bar{Z}bd*\bar{Z}2*\bar{U}cs+3*N1^{2}*\bar{Z}3*\bar{Z}bd*\bar{Z}ws*\bar{U}as)/$
$N1/\bar{Z}bs/N2/(6*\bar{Z}wd*\bar{Z}3+3*\bar{Z}bd*\bar{Z}3+2*Rd*\bar{Z}wd+Rd*\bar{Z}bd+3*Rd*\bar{Z}3)$

(Eq. 30) $\bar{U}cp =$

$$-1/3*(-6*N1^{2}*\bar{Z}3*Rd*\bar{Z}ws*\bar{U}cs+3*N1^{2}*\bar{Z}3*Rd*\bar{Z}2*\bar{U}as+$$
$$3*N1^{2}*\bar{Z}3*Rd*\bar{Z}2*\bar{U}bs+3*N1^{2}*\bar{Z}3*\bar{Z}bd*\bar{Z}2*\bar{U}bs-6*N1^{2}*\bar{Z}3*\bar{Z}bd*\bar{Z}ws*\bar{U}cs-$$
$$12*N1^{2}*\bar{Z}3*\bar{Z}wd*\bar{Z}2*\bar{U}cs+6*N1^{2}*\bar{Z}3*\bar{Z}wd*\bar{Z}ws*\bar{U}as+$$
$$6*N1^{2}*\bar{Z}3*\bar{Z}wd*\bar{Z}ws*\bar{U}bs+3*N1^{2}*\bar{Z}3*\bar{Z}bd*\bar{Z}2*\bar{U}as-3*\bar{Z}bs*\bar{Z}1*N3^{2}*\bar{Z}bd*\bar{U}as+$$
$$3*N1^{2}*\bar{Z}3*Rd*\bar{Z}ws*\bar{U}as+3*N1^{2}*\bar{Z}3*Rd*\bar{Z}ws*\bar{U}bs-2*N1^{2}*\bar{Z}2*\bar{U}cs*Rd*\bar{Z}bd-$$
$$4*N1^{2}*\bar{Z}2*\bar{U}cs*Rd*\bar{Z}wd-3*\bar{Z}bs*\bar{Z}1*N3^{2}*\bar{Z}bd*\bar{U}bs-6*\bar{Z}bs*\bar{Z}1*N3^{2}*\bar{Z}wd*\bar{U}cs-$$
$$6*\bar{Z}bs*\bar{Z}1*N3^{2}*\bar{Z}wd*\bar{U}as-6*N1^{2}*\bar{Z}3*Rd*\bar{Z}2*\bar{U}cs-6*\bar{Z}bs*\bar{Z}1*N3^{2}*\bar{Z}wd*\bar{U}bs-$$
$$3*\bar{Z}bs*\bar{Z}1*N3^{2}*Rd*\bar{U}cs-3*\bar{Z}bs*\bar{Z}1*N3^{2}*\bar{Z}bd*\bar{U}cs-3*\bar{Z}bs*\bar{Z}1*N3^{2}*Rd*\bar{U}bs-$$
$$3*\bar{Z}bs*\bar{Z}1*N3^{2}*Rd*\bar{U}as-12*N1^{2}*\bar{Z}3*\bar{Z}wd*\bar{Z}ws*\bar{U}cs-6*\bar{Z}1*N2^{2}*\bar{U}cs*Rd*\bar{Z}3+$$
$$6*\bar{Z}1*N2^{2}*\bar{U}as*\bar{Z}wd*\bar{Z}3-6*\bar{Z}1*N2^{2}*\bar{U}cs*\bar{Z}bd*\bar{Z}3-12*\bar{Z}1*N2^{2}*\bar{U}cs*\bar{Z}wd*\bar{Z}3+$$
$$\bar{Z}1*N2^{2}*\bar{U}as*Rd*\bar{Z}bd+2*\bar{Z}1*N2^{2}*\bar{U}as*Rd*\bar{Z}wd+3*\bar{Z}1*N2^{2}*\bar{U}as*\bar{Z}bd*\bar{Z}3-$$
$$2*\bar{Z}1*N2^{2}*\bar{U}cs*Rd*\bar{Z}bd-4*\bar{Z}1*N2^{2}*\bar{U}cs*Rd*\bar{Z}wd+3*\bar{Z}1*N2^{2}*\bar{U}bs*Rd*\bar{Z}3+$$
$$N1^{2}*\bar{Z}ws*\bar{U}bs*Rd*\bar{Z}bd+6*N1^{2}*\bar{Z}3*\bar{Z}wd*\bar{Z}2*\bar{U}bs+2*N1^{2}*\bar{Z}ws*\bar{U}bs*Rd*\bar{Z}wd+$$
$$3*\bar{Z}1*N2^{2}*\bar{U}as*Rd*\bar{Z}3+6*N1^{2}*\bar{Z}3*\bar{Z}wd*\bar{Z}2*\bar{U}as+6*\bar{Z}1*N2^{2}*\bar{U}bs*\bar{Z}wd*\bar{Z}3+$$
$$2*\bar{Z}1*N2^{2}*\bar{U}bs*Rd*\bar{Z}wd+3*\bar{Z}1*N2^{2}*\bar{U}bs*\bar{Z}bd*\bar{Z}3-4*N1^{2}*\bar{Z}ws*\bar{U}cs*Rd*\bar{Z}wd+$$
$$N1^{2}*\bar{Z}2*\bar{U}as*Rd*\bar{Z}bd+2*N1^{2}*\bar{Z}2*\bar{U}as*Rd*\bar{Z}wd+\bar{Z}1*N2^{2}*\bar{U}bs*Rd*\bar{Z}bd-$$
$$2*N1^{2}*\bar{Z}ws*\bar{U}cs*Rd*\bar{Z}bd+3*N1^{2}*\bar{Z}3*\bar{Z}bd*\bar{Z}ws*\bar{U}bs+N1^{2}*\bar{Z}2*\bar{U}bs*Rd*\bar{Z}bd+$$
$$2*N1^{2}*\bar{Z}2*\bar{U}bs*Rd*\bar{Z}wd+N1^{2}*\bar{Z}ws*\bar{U}as*Rd*\bar{Z}bd+2*N1^{2}*\bar{Z}ws*\bar{U}as*Rd*\bar{Z}wd-$$
$$6*N1^{2}*\bar{Z}3*\bar{Z}bd*\bar{Z}2*\bar{U}cs+3*N1^{2}*\bar{Z}3*\bar{Z}bd*\bar{Z}ws*\bar{U}as-18*N1^{2}*\bar{Z}bs*\bar{Z}3*\bar{Z}wd*\bar{U}cs-$$
$$9*N1^{2}*\bar{Z}bs*\bar{Z}3*\bar{Z}bd*\bar{U}cs-6*N1^{2}*\bar{Z}bs*\bar{U}cs*Rd*\bar{Z}wd-3*N1^{2}*\bar{Z}bs*\bar{U}cs*Rd*\bar{Z}bd-$$
$$9*N1^{2}*\bar{Z}bs*\bar{Z}3*Rd*\bar{U}cs)/N1/\bar{Z}bs/N2/(6*\bar{Z}wd*\bar{Z}3+3*\bar{Z}bd*\bar{Z}3+2*Rd*\bar{Z}wd+$$
$$Rd*\bar{Z}bd+3*Rd*\bar{Z}3)$$

As can be seen from the above equations for $\bar{U}ap$, $\bar{U}bp$ and $\bar{U}cp$, in order to calculate primary phase-to-earth voltages from measured secondary voltages $\bar{U}as$, $\bar{U}bs$ and $\bar{U}cs$, the latter voltages are preferably corrected by one or more parameters of the transformers comprising for example:

$\bar{Z}1$ = Impedance of the primary winding
$\bar{Z}2$ = Impedance of the secondary winding
$\bar{Z}3$ = Impedance of the tertiary winding
N1 = Number of turns of wire in the primary winding
N2 = Number of turns of wire in the secondary winding
N3 = Number of turns of wire in the tertiary winding

and/or by one or more parameters of the external wiring and/or burden:

the circuit connected to the secondary windings comprising for example:

$\bar{Z}ws$ = Wiring impedance of the secondary circuit
$\bar{Z}wn$ = Wiring impedance of the secondary circuit, neutral conductor
$\bar{Z}bs$ = Secondary burden impedance

the circuit connected to the tertiary windings comprising for example:

$\overline{Z}$wd = Wiring impedance of the open delta
$\overline{Z}$bd = Tertiary burden impedance
Rd = Ferroresonance (tertiary) damping resistance.

In addition, all the phases are coupled, i.e. the phase voltage of phase PA, for example, is affected by phases PB and PC through open-delta winding.

According to an embodiment, the measured secondary voltages $\overline{U}$as, $\overline{U}$bs, $\overline{U}$cs can be corrected, e.g. by utilizing exemplary equations 25-27 or 28-30, to take into account the parameters of the transformers and/or external wiring and/or burdens. After correction the secondary voltages can match the true primary voltages $\overline{U}$ap, $\overline{U}$bp and $\overline{U}$cp.

In addition to the secondary voltages, the parameters of transformers and external wiring and burdens also affect the measurement accuracy of the open-delta voltage. The correct value of the residual voltage can be calculated utilizing equations 25 to 30 by calculating the sum of the corrected secondary voltages: residual voltage = (eq25+eq26+eq27)/3 or (eq28+eq29+eq30)/3.

It should be noted, however, that the correction applied to the measured secondary voltages may be based on any combination of one or more of the parameters described above. Thus, one or more parameters in equations 25-30 may be excluded or replaced with one or more other parameters. Also further parameters may be used. The basic idea of the invention is not limited to any particular combination of parameters used or any particular equation. In addition, one or more quantities in a known relation to one or more of said parameters may be used when applying the correction to the measured secondary voltages. Such one or more quantities in a known relation to one or more of said parameters may then replace the one or more parameters in question in equations 25-30 or corresponding equations. Examples of quantities in a known relation to one or more of said parameters of the transformers and/or of the external wiring and/or burden comprise secondary currents measured from the secondary windings and a tertiary current measured from the tertiary windings. The use of these quantities is described in more detail in the following examples:

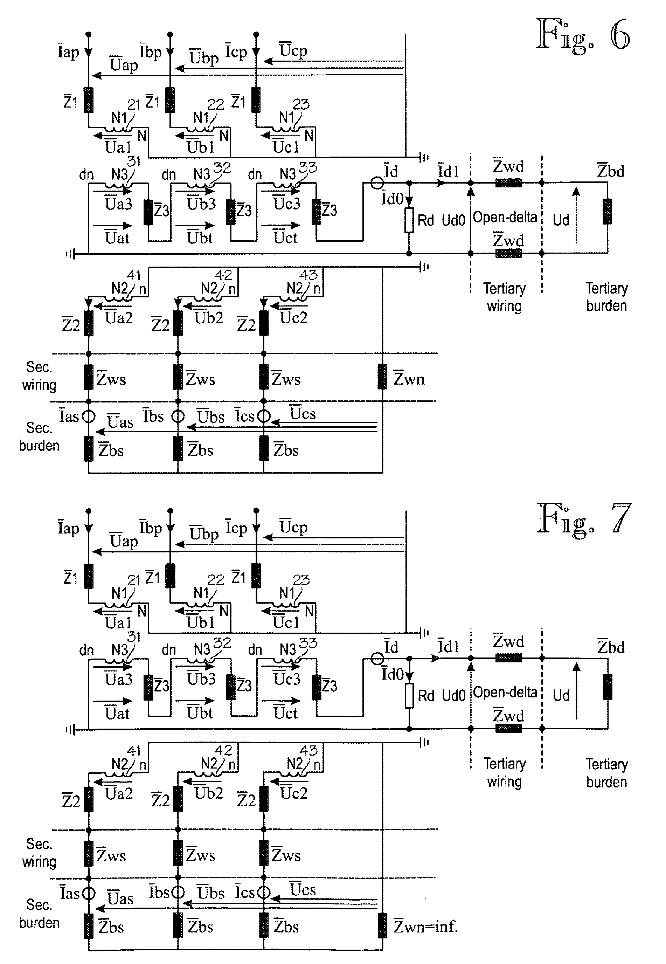

In case secondary and tertiary currents are measured as shown in the exemplary electrical equivalent schemes of Figures 6 and 7:

| | |
|---|---|
| $\overline{I}$as | = Phase PA secondary phase current |
| $\overline{I}$bs | = Phase PB secondary phase current |
| $\overline{I}$cs | = Phase PC secondary phase current |
| $\overline{I}$d | = $\overline{I}$d0 + $\overline{I}$d1 = Total tertiary current |
| $\overline{I}$d0 | = Tertiary current through damping resistor |
| $\overline{I}$d1 | = Tertiary current through tertiary burden |

Then the accurate primary phase-to-earth voltages can be obtained utilizing the following equations:

In case the secondary burden is star-connected and the common neutral conductor wiring impedance is $\overline{Z}$wn as shown in Figure 6. $\overline{Z}$ws = Wiring impedance of secondary circuit (in case the current measurement is not done at the terminals of the voltage transformer):

(Eq. 31):

$$\overline{U}_{ap} = \frac{\overline{U}_{as}}{N21} + \frac{(\overline{Z}1 \cdot N21^2 + \overline{Z}2 + \overline{Z}ws) \cdot \overline{I}_{as} + (N21 \cdot N31 \cdot \overline{Z}1) \cdot \overline{I}_d + \overline{Z}wn \cdot (\overline{I}_{as} + \overline{I}_{bs} + \overline{I}_{cs})}{N21}$$

(Eq. 32):

$$\overline{U}_{bp} = \frac{\overline{U}_{bs}}{N21} + \frac{(\overline{Z}1 \cdot N21^2 + \overline{Z}2 + \overline{Z}ws) \cdot \overline{I}_{bs} + (N21 \cdot N31 \cdot \overline{Z}1) \cdot \overline{I}_d + \overline{Z}wn \cdot (\overline{I}_{as} + \overline{I}_{bs} + \overline{I}_{cs})}{N21}$$

(Eq. 33):

$$\overline{U}_{cp} = \frac{\overline{U}_{cs}}{N21} + \frac{(\overline{Z}1 \cdot N21^2 + \overline{Z}2 + \overline{Z}ws) \cdot \overline{I}_{cs} + (N21 \cdot N31 \cdot \overline{Z}1) \cdot \overline{I}_d + \overline{Z}wn \cdot (\overline{I}_{as} + \overline{I}_{bs} + \overline{I}_{cs})}{N21}$$

In case the secondary burden is delta connected, the neutral conductor impedance $\overline{Z}wn$ equals infinity as shown in Figure 7. $\overline{Z}ws$ = Wiring impedance of secondary circuit (in case the current measurement is not done at the terminals of the voltage transformer):

$$\overline{U}_{ap} = \frac{\overline{U}_{as}}{N21} + \frac{(\overline{Z}1 \cdot N21^2 + \overline{Z}2 + \overline{Z}ws) \cdot \overline{I}_{as} + (N21 \cdot N31 \cdot \overline{Z}1) \cdot \overline{I}_d}{N21} \qquad \text{(Eq. 34)}$$

$$\overline{U}_{bp} = \frac{\overline{U}_{bs}}{N21} + \frac{(\overline{Z}1 \cdot N21^2 + \overline{Z}2 + \overline{Z}ws) \cdot \overline{I}_{bs} + (N21 \cdot N31 \cdot \overline{Z}1) \cdot \overline{I}_d}{N21} \qquad \text{(Eq. 35)}$$

$$\overline{U}_{cp} = \frac{\overline{U}_{cs}}{N21} + \frac{(\overline{Z}1 \cdot N21^2 + \overline{Z}2 + \overline{Z}ws) \cdot \overline{I}_{cs} + (N21 \cdot N31 \cdot \overline{Z}1) \cdot \overline{I}_d}{N21} \qquad \text{(Eq. 36)}$$

Where the following values are obtained e.g. from voltage transformer manufacturer or by measurements:

N21 = N2/N 1
N31 = N3/N1
N1 = Number of turns of wire in primary winding
N2 = Number of turns of wire in secondary winding
N3 = Number of turns of wire in tertiary winding
$\overline{Z}1$ = Impedance of primary winding
$\overline{Z}2$ = Impedance of secondary winding
$\overline{Z}3$ = Impedance of tertiary winding

The corrected secondary voltages can be derived by a well known ratio conversion:

$$\overline{U}_{ascorr} = N21 \cdot \overline{U}_{ap}$$

$$\overline{U}_{bscorr} = N21 \cdot \overline{U}_{bp}$$

$$\overline{U}_{cscorr} = N21 \cdot \overline{U}_{cp}$$

Thus, according to an embodiment, when the secondary burden impedances are star-connected, the correction to the measured secondary voltages is applied on the basis of the impedance of the primary winding, the impedance of the secondary winding, the secondary wiring impedance, the secondary neutral conductor impedance, the secondary currents and the tertiary current, e.g. according to equations 31-33.

In a similar manner, according to another embodiment, when the secondary burden impedances are delta-connected, the correction to the measured secondary voltages is applied on the basis of the impedance of the primary winding, the impedance of the secondary winding, the secondary wiring impedance, the secondary currents and the tertiary current e.g. according to equations 34-36.

An advantage of using the secondary currents measured from the secondary windings and the tertiary current measured from the tertiary windings in the correction is that e.g. the burden impedance values are not needed.

Also the corrected value of residual voltage may be calculated by calculating the sum of the corrected voltages:

$$\text{The corrected residual voltage on a primary voltage level} =$$

$$\overline{U}_{0corr} = (\overline{U}_{ap} + \overline{U}_{bp} + \overline{U}_{cp})/3$$

In case the ratio of the tertiary winding N3 to the primary winding N1 is N3/N1 = 1/sqrt(3), then

$$\text{the corrected residual voltage on a tertiary voltage level} =$$

$$\overline{U}_{0corr} = (\overline{U}_{ap} + \overline{U}_{bp} + \overline{U}_{cp}) \cdot N31$$

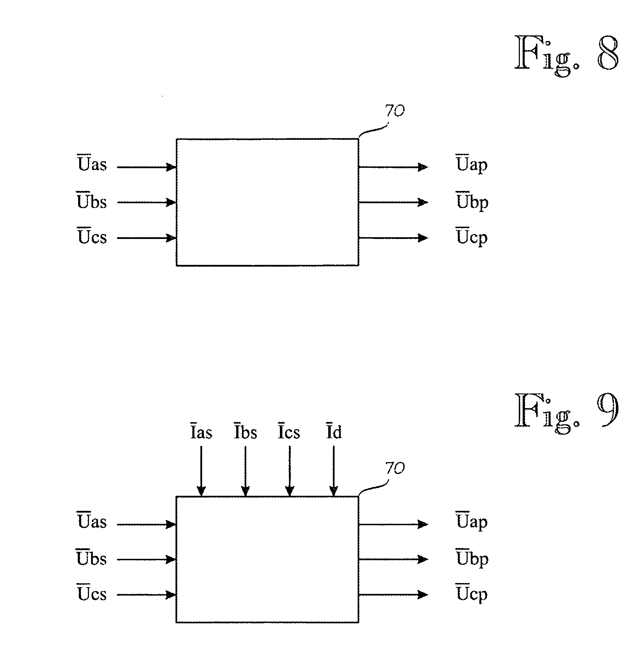

An apparatus according to any one of the above embodiments, or a combination thereof, may be implemented as one unit or as two or more separate units that are configured to implement the functionality of the various embodiments. Here the term 'unit' refers generally to a physical or logical entity, such as a physical device or a part thereof or a software routine. Figure 8 illustrates an example of a device 70 that receives as inputs measured secondary voltages $\overline{U}$as, $\overline{U}$bs, $\overline{U}$cs and determines and outputs the values of the primary voltages $\overline{U}$ap, $\overline{U}$bp, $\overline{U}$cp applying the correction as described above in connection with equations 25-30, for example. The necessary parameters of the transformers and/or one or more parameters of the external wiring and/or burden that are used in the correction procedure may be stored in the device 70. Such parameters may be user definable via a suitable user interface (not shown) to the device 70, for example. Figure 9 illustrates another example of the device 70 which in this embodiment further receives measured secondary currents $\overline{I}$as, $\overline{I}$bs, $\overline{I}$cs and tertiary current $\overline{I}$d as inputs and uses also them in the correction procedure as described above in connection with equations 31-36, for example. Device 70 may be part of the transformer configuration 11, 12, 13 or a separate entity.

An apparatus according to any one of the embodiments, such as device 70, may be implemented by means of a computer or corresponding digital signal processing equipment provided with suitable software, for example. Such a computer or digital signal processing equipment preferably comprises at least a working memory (RAM) providing storage area for arithmetical operations and a central processing unit (CPU), such as a general-purpose digital signal processor. The CPU may comprise a set of registers, an arithmetic logic unit, and a control unit. The control unit is controlled by a sequence of program instructions transferred to the CPU from the RAM. The control unit may contain a number of microinstructions for basic operations. The implementation of microinstructions may vary depending on the CPU design. The program instructions may be coded by a programming language, which may be a high-level programming language, such as C, Java, etc., or a low-level programming language, such as a machine language, or an assembler. The computer may also have an operating system which may provide system services to a computer program written with the program instructions. The computer or another apparatus implementing the invention further preferably comprises suitable input means and output means. It is also possible to use a specific integrated circuit or circuits, and/or discrete components and devices for implementing the functionality according to any one of the embodiments.

The invention can be implemented in existing system elements or by using separate dedicated elements or devices in a centralized or distributed manner. Present devices for electric systems may comprise processors and memory that can be utilized in the functions according to embodiments of the invention. Thus, all modifications and configurations required for implementing an embodiment of the invention e.g. in existing devices may be performed as software routines, which may be implemented as added or updated software routines. If the functionality of the invention is implemented by software, such software can be provided as a computer program product comprising computer program code which, when run on a computer, causes the computer or a corresponding arrangement to perform the functionality according to the invention, as described above. Such a computer program code may be stored or generally embodied on a computer readable medium, such as suitable memory, e.g. a flash memory or a disc memory from which it is loadable to the unit or units executing the program code. In addition, such a computer program code implementing the invention may be loaded to the unit or units executing the computer program code via a suitable data network, for example, and it may replace or update a possibly existing program code.

It will be obvious to a person skilled in the art that, as the technology advances, the inventive concept can be implemented in various ways. The invention and its embodiments are not limited to the examples described above but may vary within the scope of the claims.

**Claims**

1. A method for voltage measurement with a transformer configuration comprising three single pole voltage transformers (11, 12, 13) each having at least a primary winding (21, 22, 23), a secondary winding (41, 42, 43) and a tertiary winding (31, 32, 33), wherein the primary windings are connected to primary voltages and the tertiary windings of the voltage transformers are open-delta connected with each other, the method comprising:

   measuring secondary voltages from the secondary windings (41, 42, 43); and
   determining values of the primary voltages on the basis of the secondary voltages measured from the secondary windings (41, 42, 43) and a turns ratio between the primary winding (21, 22, 23) and the secondary winding, **characterized in that** the determining of the values of the primary voltages comprises:

      applying a correction to the measured secondary voltages on the basis of one or more parameters of the voltage transformers (11, 12, 13) and/or one or more quantities in a known relation to one or more parameters of the voltage transformers, one or more parameters of a circuit connected to the secondary windings (41, 42, 43) and/or one or more quantities in a known relation to one or more parameters of the circuit connected to the secondary windings, and one or more parameters of a circuit connected to the tertiary windings (31, 32, 33) and/or one or more quantities in a known relation to one or more parameters of the circuit connected to the tertiary windings.

2. A method as claimed in claim 1, **characterized in that** the parameters of the voltage transformers (11, 12, 13) comprise an impedance of the primary winding (21, 22, 23), an impedance of the secondary winding (41, 42, 43), an impedance of the tertiary winding (31, 32, 33), a number of turns of wire in the primary winding, a number of turns of wire in the secondary winding and a number of turns of wire in the tertiary winding.

3. A method as claimed in claim 1 or 2, **characterized in that** the parameters of the circuit connected to the secondary windings (41, 42, 43) comprise a secondary burden impedance and/or a secondary wiring impedance.

4. A method as claimed in claim 3, **characterized in that** the parameters of the circuit connected to the secondary windings (41, 42, 43) comprise a secondary neutral conductor impedance when the secondary burden impedances are star-connected.

5. A method as claimed in any one of claims 1 - 4, **characterized in that** the parameters of the circuit connected to the tertiary windings (31, 32, 33) comprise one or more of the following: a resistance of a tertiary damping resistor, a tertiary burden impedance, a tertiary wiring impedance.

6. A method as claimed in any one of claims 1 - 5, **characterized in that** the correction to the measured secondary voltages is applied, when the secondary burden impedances are star-connected, on the basis of the impedance of the primary winding (21, 22, 23), the impedance of the secondary winding (41, 42, 43), the secondary wiring impedance, the secondary neutral conductor impedance, secondary currents measured from the secondary windings and a tertiary current measured from the tertiary windings.

7. A method as claimed in any one of claims 1 - 5, **characterized in that** the correction to the measured secondary voltages is applied, when the secondary burden impedances are delta-connected, on the basis of the impedance of the primary winding (21, 22, 23), the impedance of the secondary winding (41, 42, 43), the secondary wiring impedance, secondary currents measured from the secondary windings and a tertiary current measured from the tertiary windings.

8. A computer program product comprising computer program code, wherein execution of the program code in a computer causes the computer to carry out the steps of the method according to any one of claims 1 to 7.

9. An arrangement for voltage measurement with a transformer configuration comprising three single pole voltage transformers (11, 12, 13) each having at least a primary winding (21, 22, 23), a secondary winding (41, 42, 43) and a tertiary winding (31, 32, 33), wherein the primary windings are arranged to be connected to primary voltages and the tertiary windings of the voltage transformers are open-delta connected with each other, the arrangement comprising:

means (70) for determining values of the primary voltages on the basis of secondary voltages measured from the secondary windings (41, 42, 43) and a turns ratio between the primary winding (21, 22, 23) and the secondary winding, **characterized in that** the means (70) for determining the values of the primary voltages are arranged to apply a correction to the measured secondary voltages on the basis of one or more parameters of the voltage transformers (11, 12, 13) and/or one or more quantities in a known relation to one or more parameters of the voltage transformers, one or more parameters of a circuit connected to the secondary windings (41, 42, 43) and/or one or more quantities in a known relation to one or more parameters of the circuit connected to the secondary windings, and one or more parameters of a circuit connected to the tertiary windings (31, 32, 33) and/or one or more quantities in a known relation to one or more parameters of the circuit connected to the tertiary windings.

10. An arrangement as claimed in claim 9, **characterized in that** the parameters of the voltage transformers (11, 12, 13) comprise an impedance of the primary winding (21, 22, 23), an impedance of the secondary winding (41, 42, 43), an impedance of the tertiary winding (31, 32, 33), a number of turns of wire in the primary winding, a number of turns of wire in the secondary winding and a number of turns of wire in the tertiary winding.

11. An arrangement as claimed in claim 9 or 10, **characterized** in that the parameters of the circuit connected to the secondary windings (41, 42, 43) comprise a secondary burden impedance and/or a secondary wiring impedance.

12. An arrangement as claimed in claim 11, **characterized in that** the parameters of the circuit connected to the secondary windings (41, 42, 43) comprise a secondary neutral conductor impedance when the secondary burden impedances are star-connected.

13. An arrangement as claimed in any one of claims 9 - 12, **characterized in that** the parameters of the circuit connected to the tertiary windings (31, 32, 33) comprise one or more of the following: a resistance of a tertiary damping resistor, a tertiary burden impedance, a tertiary wiring impedance.

14. An arrangement as claimed in any one of claims 9 - 13, **characterized in that** the means (70) for determining the values of the primary voltages are arranged to apply the correction to the measured secondary voltages, when the secondary burden impedances are star-connected, on the basis of the impedance of the primary winding (21, 22, 23), the impedance of the secondary winding (41, 42, 43), the secondary wiring impedance, the secondary neutral conductor impedance, secondary currents measured from the secondary windings and a tertiary current measured from the tertiary windings.

15. An arrangement as claimed in any one of claims 9-13, **characterized in that** the means (70) for determining the values of the primary voltages are arranged to apply the correction to the measured secondary voltages, when the secondary burden impedances are delta-connected, on the basis of the impedance of the primary winding (21, 22, 23), the impedance of the secondary winding (41, 42, 43), the secondary wiring impedance, secondary currents measured from the secondary windings and a tertiary current measured from the tertiary windings.

16. An arrangement as claimed in any one of claims 10 - 15, **characterized in that** the arrangement comprises the transformer configuration.

**Patentansprüche**

1. Ein Verfahren zur Spannungsmessung mit einer Transformatorkonfiguration, die drei einpolige Spannungstransformatoren (11, 12, 13) aufweist, von denen jede mindestens eine Primärwicklung (21, 22, 23), eine Sekundärwicklung (41, 42, 43) und eine Tertiärwicklung (31, 32, 33) aufweist, wobei die Primärwicklungen mit Primärspannungen verbunden sind und die Tertiärwicklungen der Spannungstransformatoren miteinander in offener Dreiecksschaltung stehen, wobei das Verfahren Folgendes aufweist:

Sekundärspannungen von den Sekundärwicklungen (41, 42, 43) messen; und

Werte für die Primärspannungen auf der Basis von den Sekundärspannungen, gemessen von den Sekundärwicklungen (41, 42, 43), und einem Windungszahlenverhältnis zwischen der Primärwicklung (21, 22, 23) und der Sekundärwicklung bestimmen, **dadurch gekennzeichnet, dass** das Bestimmen der Werte der Primärspannungen Folgendes aufweist:

eine Korrektur der gemessenen Sekundärspannungen vornehmen auf der Basis von einem oder mehreren Parametern der Spannungstransformatoren (11, 12, 13) und/oder einer oder mehreren Quantitäten in einer bekannten Relation zu einem oder mehreren Parametern der Spannungstransformatoren, einem oder mehreren Parametern eines mit den Sekundärwicklungen (41, 42, 43) verbundenen Stromkreises, und/oder von einer oder mehreren Quantitäten in einer bekannten Relation zu einem oder mehreren Parametern des mit den Sekundärwicklungen verbundenen Stromkreises, und einem oder mehreren Parametern eines mit den Tertiärwicklungen (31, 32, 33) verbundenen Stromkreises und/oder von einer oder mehreren Quantitäten in einer bekannten Relation zu einem oder mehreren Parametern des mit den Tertiärwicklungen verbundenen Stromkreises.

2. Ein Verfahren gemäß dem Patentanspruch 1 **dadurch gekennzeichnet, dass** die Parameter der Spannungstransformatoren (11, 12, 13) eine Impedanz der Primärwicklung (21, 22, 23), eine Impedanz der Sekundärwicklung (41, 42, 43), eine Impedanz der Tertiärwicklung (31, 32, 33), eine Anzahl von Drahtwindungen in der Primärwicklung, eine Anzahl von Drahtwindungen in der Sekundärwicklung und eine Anzahl von Drahtwindungen in der Tertiärwicklung aufweisen.

3. Ein Verfahren gemäß dem Patentanspruch 1 oder 2 **dadurch gekennzeichnet, dass** die Parameter des mit den Sekundärwicklungen (41, 42, 43) verbundenen Stromkreises eine sekundäre Belastungsimpedanz und/oder eine sekundäre Verdrahtungsimpedanz aufweisen.

4. Ein Verfahren gemäß dem Patentanspruch 3 **dadurch gekennzeichnet, dass** die Parameter des mit den Sekundärwicklungen (41, 42, 43) verbundenen Stromkreises eine sekundäre neutrale Leiterimpedanz aufweisen, wenn die sekundären Belastungsimpedanzen in Stern geschaltet sind.

5. Ein Verfahren gemäß einem der Patentansprüche 1 - 4 **dadurch gekennzeichnet, dass** die Parameter des mit den Tertiärwicklungen (31, 32, 33) verbundenen Stromkreises einen oder mehrere der folgenden aufweisen: einen Widerstand eines tertiären Dämpfungswiderstands, eine tertiäre Belastungsimpedanz, eine tertiäre Verdrahtungsimpedanz.

6. Ein Verfahren gemäß einem der Patentansprüche 1 - 5 **dadurch gekennzeichnet, dass** die Korrektur der gemessenen Sekundärspannungen vorgenommen wird, wenn die sekundären Belastungsimpedanzen in Stern geschaltet sind, auf der Basis von der Impedanz der Primärwicklung (21, 22, 23), der Impedanz der Sekundärwicklung (41, 42, 43), der sekundären Verdrahtungsimpedanz, der sekundären neutralen Leiterimpedanz, von den sekundären, von den Sekundärwicklungen gemessenen Strome und einem tertiären, von den Tertiärwicklungen gemessenen Strom.

7. Ein Verfahren gemäß einem der Patentansprüche 1 - 5 **dadurch gekennzeichnet, dass** die Korrektur der gemessenen Sekundärspannungen vorgenommen wird, wenn die sekundären Belastungsimpedanzen in Dreieckschaltung stehen, auf der Basis von der Impedanz der Primärwicklung (21, 22, 23), der Impedanz der Sekundärwicklung (41, 42, 43), der sekundären Verdrahtungsimpedanz, der sekundären, von den Sekundärwicklungen gemessenen Strome und einem von den Tertiärwicklungen gemessenen tertiären Strom.

8. Ein Computerprogrammprodukt, das einen Computerkode aufweist, wobei die Durchführung des Programmkodes in einem Computer den Computer veranlasst, die Schritte des Verfahrens gemäß einem der Patentansprüche 1 bis 7 auszuführen.

9. Eine Anordnung zur Spannungsmessung mit einer Transformatorkonfiguration, die drei einpolige Spannungstransformatoren (11, 12, 13) aufweist, von denen jede mindestens eine Primärwicklung (21, 22, 23), eine Sekundärwicklung (41, 42, 43) und eine Tertiärwicklung (31, 32, 33) hat, wobei die Primärwicklungen angeordnet sind, mit den Primärspannungen verbunden zu werden, und die Tertiärwicklungen der Spannungstransformatoren miteinander in offener Dreieckschaltung stehen, wobei die Anordnung Folgendes aufweist:

Mittel (70) zur Bestimmung von Werten der Primärspannungen auf der Basis von Sekundärspannungen, die von den Sekundärwicklungen (41, 42, 43) gemessen wurden, und einem Windungszahlenverhältnis zwischen der Primärwicklung (21, 22, 23) und der Sekundärwicklung, **dadurch gekennzeichnet, dass** die Mittel (70) zur Bestimmung der Werte der Primärspannungen angeordnet sind, eine Korrektur der gemessenen Sekundärspannungen vorzunehmen auf der Basis von einem oder mehreren Parametern der Spannungstransformatoren (11, 12, 13) und/oder einer oder mehreren Quantitäten in einer bekannten Relation zu einem oder mehreren Parametern der Spannungstransformatoren, einem oder mehreren Parametern eines mit den Sekundärwicklungen (41, 42, 43) verbundenen Stromkreises, und/oder einer oder mehreren Quantitäten in einer bekannten Relation zu einem oder mehreren Parametern des mit der Sekundärwicklung verbundenen Stromkreises und einem oder mehreren Parametern eines mit den Tertiärwicklungen (31, 32, 33) verbundenen Stromkreises und/oder einer oder mehreren Quantitäten in einer bekannten Relation zu einem oder mehreren Parametern des mit den Tertiärwicklungen verbundenen Stromkreises.

10. Eine Anordnung gemäß dem Patentanspruch 9 **dadurch gekennzeichnet, dass** die Parameter der Spannungstransformatoren (11, 12, 13) eine Impedanz der Primärwicklung (21, 22, 23), eine Impedanz der Sekundärwicklung (41, 42, 43), eine Impedanz der Tertiärwicklung (31, 32, 33), eine Anzahl von Drahtwindungen in der Primärwicklung, eine Anzahl von Drahtwindungen in der Sekundärwicklung und eine Anzahl von Drahtwindungen in der Tertiärwicklung aufweisen.

11. Eine Anordnung gemäß dem Patentanspruch 9 oder 10 **dadurch gekennzeichnet, dass** die Parameter des mit den Sekundärwicklungen (41, 42, 43) verbundenen Stromkreises eine sekundäre Belastungsimpedanz und/oder eine sekundäre Verdrahtungsimpedanz aufweisen.

12. Eine Anordnung gemäß dem Patentanspruch 11 **dadurch gekennzeichnet, dass** die Parameter des mit den Sekundärwicklungen (41, 42, 43) verbundenen Stromkreises eine sekundäre neutrale Leiterimpedanz aufweisen, wenn die sekundären Belastungsimpedanzen in Stern geschaltet sind.

13. Eine Anordnung gemäß einem der Patentansprüche 9 - 12 **dadurch gekennzeichnet, dass** die Parameter des mit den Tertiärwicklungen (31, 32, 3) verbundenen Stromkreises einen oder mehrere der folgenden aufweisen: einen Widerstand eines tertiären Dämpfungswiderstandes, eine tertiäre Belastungsimpedanz, eine tertiäre Verdrahtungsimpedanz.

14. Eine Anordnung gemäß einem der Patentansprüche 9 - 13 **dadurch gekennzeichnet, dass** die Mittel (70) zur Bestimmung der Werte der Primärspannungen angeordnet sind, die Korrektur der gemessenen Sekundärspannungen vorzunehmen, wenn die sekundären Belastungsimpedanzen in Stern geschaltet sind, auf der Basis von der Impedanz der Primärwicklung (21, 22, 23), der Impedanz der Sekundärwicklung (41, 42, 43), der sekundären Verdrahtungsimpedanz, der sekundären neutralen Leiterimpedanz, der sekundären, von den Sekundärwicklungen gemessenen Strome und einem tertiären, von den Tertiärwicklungen gemessenen Strom.

15. Eine Anordnung gemäß einem der Patentansprüche 9 - 13 **dadurch gekennzeichnet, dass** die Mittel (70) zur Bestimmung der Werte der Primärspannungen angeordnet sind, die Korrektur der gemessenen Sekundärspannungen vorzunehmen, wenn die sekundären Belastungsimpedanzen in Dreieckschaltung stehen, auf der Basis von der Impedanz der Primärwicklung (21, 22, 23), der Impedanz der Sekundärwicklung (41, 42, 43), der sekundären Verdrahtungsimpedanz, der sekundären, von den Sekundärwicklungen gemessenen Strome und einem tertiären, von den Tertiärwicklungen gemessenen Strom.

16. Eine Anordnung gemäß einem der Patentansprüche 10 - 15 **dadurch gekennzeichnet, dass** die Anordnung die Transformatorkonfiguration aufweist.

**Revendications**

1. Méthode pour la mesure de la tension avec une configuration de transformateurs comprenant trois transformateurs de tension unipolaires (11, 12, 13) ayant chacun au moins un enroulement primaire (21, 22, 23), un enroulement secondaire (41, 42, 43) et un enroulement tertiaire (31, 32, 33), dans laquelle les enroulements primaires sont reliés à des tensions primaires et les enroulements tertiaires des transformateurs de tension sont reliés entre eux en delta ouvert, la méthode comprenant :

la mesure de tensions secondaires des enroulements secondaires (41, 42, 43) ; et

la détermination de valeurs des tensions primaires sur la base des tensions secondaires mesurées à partir des enroulements secondaires (41, 42, 43) et d'un rapport de tours entre l'enroulement primaire (21, 22, 23) et l'enroulement secondaire, **caractérisée en ce que** la détermination des valeurs des tensions primaires comprend :

l'application d'une correction aux tensions secondaires mesurées, sur la base d'un ou plusieurs paramètres des transformateurs de tension (11, 12, 13), et/ou d'une ou plusieurs quantités dans une relation connue avec un ou plusieurs paramètres des transformateurs de tension, d'un ou plusieurs paramètres d'un circuit relié aux enroulements secondaires (41, 42, 43) et/ou d'une ou plusieurs quantités dans une relation connue avec un ou plusieurs paramètres du circuit relié aux enroulements secondaires, et d'un ou plusieurs paramètres d'un circuit relié aux enroulements tertiaires (31, 32, 33) et/ou d'une ou plusieurs quantités dans une relation connue avec un ou plusieurs paramètres du circuit relié aux enroulements tertiaires.

2. Méthode selon la revendication 1, **caractérisée en ce que** les paramètres des transformateurs de tension (11, 12, 13) comprennent une impédance de l'enroulement primaire (21, 22, 23), une impédance de l'enroulement secondaire (41, 42, 43), une impédance de l'enroulement tertiaire (31, 32, 33), un nombre de tours de fil dans l'enroulement primaire, un nombre de tours de fil dans l'enroulement secondaire et un nombre de tours de fil dans l'enroulement tertiaire.

3. Méthode selon la revendication 1 ou 2, **caractérisée en ce que** les paramètres du circuit relié aux enroulements secondaires (41, 42, 43) comprennent une impédance de charge secondaire et/ou une impédance de câblage secondaire.

4. Méthode selon la revendication 3, **caractérisée en ce que** les paramètres du circuit relié aux enroulements secondaires (41, 42, 43) comprennent une impédance de conducteur neutre secondaire lorsque les impédances de charge secondaire sont reliées en étoile.

5. Méthode selon l'une quelconque des revendications 1 à 4, **caractérisée en ce que** les paramètres du circuit relié aux enroulements tertiaires (31, 32, 33) comprennent une ou plusieurs de ce qui suit : une résistance électrique d'une résistance d'amortissement tertiaire, une impédance de charge tertiaire, une impédance de câblage tertiaire.

6. Méthode selon l'une quelconque des revendications 1 à 5, **caractérisée en ce que** la correction des tensions secondaires mesurées est appliquée, lorsque les impédances de charge secondaire sont reliées en étoile, sur la base de l'impédance de l'enroulement primaire (21, 22, 23), de l'impédance de l'enroulement secondaire (41, 42, 43), de l'impédance de câblage secondaire, de l'impédance de conducteur neutre secondaire, des courants secondaires mesurés à partir des enroulements secondaires et d'un courant tertiaire mesuré à partir des enroulements tertiaires.

7. Méthode selon l'une quelconque des revendications 1 à 5, **caractérisée en ce que** la correction des tensions secondaires mesurées est appliquée, lorsque les impédances de charge secondaire sont reliées en delta, sur la base de l'impédance de l'enroulement primaire (21, 22, 23), de l'impédance de l'enroulement secondaire (41, 42, 43), de l'impédance de câblage secondaire, des courants secondaires mesurés à partir des enroulements secondaires et d'un courant tertiaire mesuré à partir des enroulements tertiaires.

8. Produit de programme informatique comprenant un code de programme informatique, dans lequel l'exécution du code de programme dans un ordinateur amène l'ordinateur à effectuer les étapes de la méthode selon l'une quelconque des revendications 1 à 7.

9. Agencement pour la mesure de la tension avec une configuration de transformateurs comprenant trois transformateurs de tension unipolaires (11, 12, 13) ayant chacun au moins un enroulement primaire (21, 22, 23), un enroulement secondaire (41, 42, 43) et un enroulement tertiaire (31, 32, 33), dans lequel les enroulements primaires sont agencés pour être reliés à des tensions primaires et les enroulements tertiaires des transformateurs de tension sont reliés entre eux en delta ouvert, l'agencement comprenant :

des moyens (70) pour effectuer la détermination de valeurs des tensions primaires sur la base des tensions secondaires mesurées à partir des enroulements secondaires (41, 42, 43) et d'un rapport de tours entre l'enroulement primaire (21, 22, 23) et l'enroulement secondaire, **caractérisés en ce que** les moyens (70) pour effectuer la détermination des valeurs des tensions primaires sont agencés pour appliquer une correction aux tensions secondaires mesurées, sur la base d'un ou plusieurs paramètres des transformateurs de tension (11, 12, 13), et/ou d'une ou plusieurs quantités dans une relation connue avec un ou plusieurs paramètres des transformateurs de tension, d'un ou plusieurs paramètres d'un circuit relié aux enroulements secondaires (41, 42, 43) et/ou d'une ou plusieurs quantités dans une relation connue avec un ou plusieurs paramètres du circuit relié aux enroulements secondaires, et d'un ou plusieurs paramètres d'un circuit relié aux enroulements tertiaires (31, 32, 33) et/ou d'une ou plusieurs quantités dans une relation connue avec un ou plusieurs paramètres du circuit relié aux enroulements tertiaires.

10. Agencement selon la revendication 9, **caractérisé en ce que** les paramètres des transformateurs de tension (11, 12, 13) comprennent une impédance de l'enroulement primaire (21, 22, 23), une impédance de l'enroulement secondaire (41, 42, 43), une impédance de l'enroulement tertiaire (31, 32, 33), un nombre de tours de fil dans l'enroulement primaire, un nombre de tours de fil dans l'enroulement secondaire et un nombre de tours de fil dans l'enroulement tertiaire.

11. Agencement selon la revendication 9 ou 10, **caractérisé en ce que** les paramètres du circuit relié aux enroulements secondaires (41, 42, 43) comprennent une impédance de charge secondaire et/ou une impédance de câblage secondaire.

12. Agencement selon la revendication 11, **caractérisé en ce que** les paramètres du circuit relié aux enroulements secondaires (41, 42, 43) comprennent une impédance de conducteur neutre secondaire lorsque les impédances de charge secondaire sont reliées en étoile.

13. Agencement selon l'une quelconque des revendications 9 à 12, **caractérisé en ce que** les paramètres du circuit relié aux enroulements tertiaires (31, 32, 33) comprennent une ou plusieurs de ce qui suit : une résistance électrique d'une résistance d'amortissement tertiaire, une impédance de charge tertiaire, une impédance de câblage tertiaire.

14. Agencement selon l'une quelconque des revendications 9 à 13, **caractérisé en ce que** les moyens (70) pour effectuer la détermination des valeurs des tensions primaires sont agencés pour appliquer la correction aux tensions secondaires mesurées, lorsque les impédances de charge secondaire sont reliées en étoile, sur la base de l'impédance de l'enroulement primaire (21, 22, 23), de l'impédance de l'enroulement secondaire (41, 42, 43), de l'impédance de câblage secondaire, de l'impédance de conducteur neutre secondaire, des courants secondaires mesurés à partir des enroulements secondaires et d'un courant tertiaire mesuré à partir des enroulements tertiaires.

15. Agencement selon l'une quelconque des revendications 9 à 13, **caractérisé en ce que** les moyens (70) pour effectuer la détermination des valeurs des tensions primaires sont agencés pour appliquer la correction aux tensions secondaires mesurées, lorsque les impédances de charge secondaire sont reliées en delta, sur la base de l'impédance de l'enroulement primaire (21, 22, 23), de l'impédance de l'enroulement secondaire (41, 42, 43), de l'impédance de câblage secondaire, des courants secondaires mesurés à partir des enroulements secondaires et d'un courant tertiaire mesuré à partir des enroulements tertiaires.

16. Agencement selon l'une quelconque des revendications 10 à 15, **caractérisé en ce que** l'agencement comprend la configuration de transformateurs.

**Fig. 1**

A

Primary
winding

N

Measuring
winding

a

n

Earth-fault
winding

da

dn

**Fig. 2**

20

30

40

50

40

30

20

60

**Fig. 3**

PC

PB

PA

11

12

13

21 A

22

23

N

31 da

32

33

Rd

dn

41 n

42

43

a

Fig. 4

Fig. 5

Fig. 6

Fig. 7

Fig. 8

$\overline{U}as \longrightarrow$

$\overline{U}bs \longrightarrow$

$\overline{U}cs \longrightarrow$

70

$\longrightarrow \overline{U}ap$

$\longrightarrow \overline{U}bp$

$\longrightarrow \overline{U}cp$

Fig. 9

$\overline{I}as \quad \overline{I}bs \quad \overline{I}cs \quad \overline{I}d$

$\overline{U}as \longrightarrow$

$\overline{U}bs \longrightarrow$

$\overline{U}cs \longrightarrow$

70

$\longrightarrow \overline{U}ap$

$\longrightarrow \overline{U}bp$

$\longrightarrow \overline{U}cp$

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009091803 A